(19) Europäisches Patentamt
European Patent Office
Office européen des brevets

(11) Publication number: **0 482 920 A2**

(12) # EUROPEAN PATENT APPLICATION

(21) Application number: **91309812.5**

(22) Date of filing: **23.10.91**

(51) Int. Cl.$^5$: **H01L 31/0344,** G11B 7/24, G11C 7/00, G11C 17/12, G02F 1/35

(30) Priority: **24.10.90 JP 287455/90**
**21.06.91 JP 150142/91**

(43) Date of publication of application: **29.04.92 Bulletin 92/18**

(84) Designated Contracting States: **DE FR GB**

(71) Applicant: **Kabushiki Kaisha Toshiba**
**72, Horikawa-cho Saiwai-ku**
**Kawasaki-shi (JP)**

(72) Inventor: **Naito, Katsuyuki, c/o Intell. Prop. Div.**
**K.K. Toshiba, 1-1 Shibaura 1-chome**
**Minato-ku, Tokyo 105 (JP)**

(74) Representative: **Freed, Arthur Woolf et al**
**MARKS & CLERK 57-60 Lincoln's Inn Fields**
**London WC2A 3LS (GB)**

(54) **Organic optical element.**

(57) Disclosed is an organic optical element comprising an organic thin film having a photosensitive molecule film (5) provided between a donor molecule film (6) and an acceptor molecule film (4), and a pair of electrodes (2, 8) provided on the both side of the organic thin film. The charge-separated state formed by transfer of electrons and positive holes to acceptor molecules and donor molecules, respectively, by exciting photosensitive molecules by irradiation with the light within wavelength range which is absorbed by the photosensitive molecules, is controlled by the electric field applied from the electrodes (2, 8).

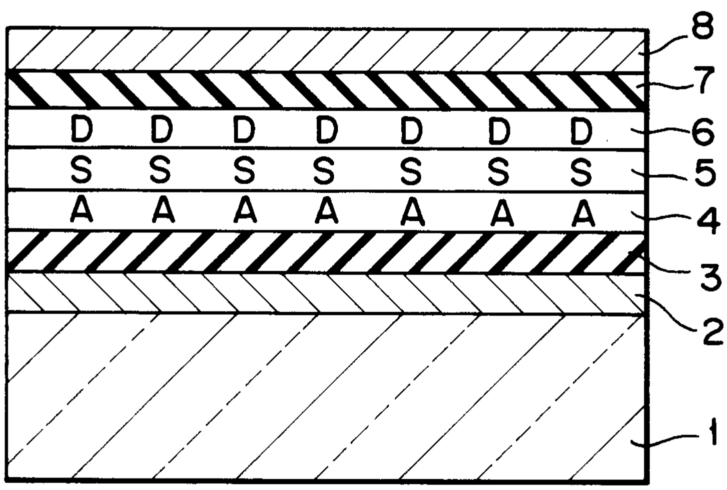


FIG. 1



Jouve, 18, rue Saint-Denis, 75001 PARIS

The present invention relates to an organic optical element which utilizes organic thin films, and is applicable to optical memory element exhibits plasticity, display element, optical shutter, optical memory and optical arithmetic element.

In the fields of advancing technologies of semiconductor, computer and software, data processing analogous to the functions of human brain instead of the serial processing using the combination of 0 and 1 is going to be the target of the study. In view of the functions of the elements, an element exhibits plasticity is significantly required. Generally, the element with plasticity means such an element that changes in characteristics depending on the external stimulation or time. Human memory is quite plastic, i.e., the memories of important things, repeatedly learned things and the event which occurred only once but was quite impressive, are maintained for a long time, while the memories other than those listed above are lost as time elapses. Such function of the brain is considered to be due to the characteristics of neurons which serve as elements, and artificial elements are extensively studied to resemble these functions.

On the other hand, various electronic devices utilizing super-thin films such as Langmuir-Brodgett films (LB films) of organic materials are studied recently in order to obtain the elements which have flexibility in element construction and can be microminiaturized at molecular level. Such studies are disclosed in, for example, Published Unexamined Japanese Patent Application Nos. 52-35587, 55-17505, 57-196143, 60-239739 and 61-37891. The applicant of the present invention also disclosed the organic thin film elements comprising donor molecules and acceptor molecules together and the method of manufacturing the same in Published Unexamined Japanese Patent Application Nos. 62-65477, 62-76551, 62-221593 and 62-284786 etc. These elements exhibit various functions by effecting the electron transfer between the donor molecules and the acceptor molecules by using the external energy such as voltage or light. In these elements, the electron transfer is caused at a certain threshold, beyond which the state that the electron has transferred does not change along with the time. Within the range below threshold, however, the initial state is recovered within a quite short period. Accordingly, they cannot be used as the elements with plasticity depending on time.

As the examples of the recent attempts to obtain the elements with plasticity using organic thin films, there are studies on change in conductivity of conductive polymer depending on the number of repetitive applications of current pulses (Preprint of the 9th symposium on novel functional element technology: The fundamentals of the industry in coming generation, p203, 1990) and on time dependence of current switching characteristic of vacuum deposited lead phthalocyanine film (Preprint of the 9th symposium on novel functional element technology: The fundamentals of industry in coming generation, p209, 1990 and Published Unexamined Japanese Patent Application No. 3-137897). The elements obtained in these studies, however, involve the problems of timeconsuming information writing, difficulty in modification or control of element characteristics, and difficulty in high integration of elements.

Another characteristic of the human data processing is parallel processing. With this regard, attention is recently paid to an element using light as a medium instead of electron. When electron is used as a medium, it is difficult to communicate the elements to each other as desired due to the requirement of separation of wirings and signals, resulting in difficulty in parallel operation of two or more elements. On the other hand, there is no problem of wiring when light is used as a medium, parallel processing can advantageously be conducted by means of locating the elements spatially as desired. The use of light as a medium, however, suffers from the difficulty in constructing switching or memory elements like Si semiconductor elements.

In the liquid crystal element, for example, the orientation of liquid crystal molecules is controlled to change the transmittance or reflectance of the liquid crystal layer by an external field, generally an electric field, whereby obtaining the desired element functions. Accompanying the recent development of the optoelectronics, the liquid crystal elements have been also required to have a function similar to those of a optical switch, where the orientation of the liquid crystal molecules is controlled by means of light. To comply with such need, an element is proposed wherein a substrate is covered with an LB film or adsorbed monomolecular film of azobenzene derivative molecules on which a liquid crystal layer is provided. In this element, it is reported that the orientation of the liquid crystal molecules can be controlled by utilizing the cis-trans configuration change of the azobenzene skeleton caused by irradiation with light (For example, see, Preprint of polymer meeting, Vol. 38, p2410 and 2413, 1989). This element, however, suffers from the difficulty in controlling the pretilt angle of the liquid crystal molecules due to the direct contact between the liquid crystal molecule and azobenzene derivative. A liquid crystal requiring great pretilt angle such as a ferroelectric liquid crystal is especially not applicable to the element. This element can not be used as the element with plasticity since it is also difficult to alter the threshold intensity of controlling light in order to cause the orientation change of the liquid crystal molecules or to control the memory characteristics. Recently, an element is reported wherein the orientation of the liquid crystal molecules can be controlled by utilizing the change in resistance of amorphous Si film caused by the irradiation with light (Nikkei electronics, issue of Feb. 4, 1991, p86). This element, however, also involves the problem of the absence of memory characteristics.

In the case of an element using an organic molecules having non-linear optical effect, it is possible to realize ON/OFF of light signal, switching of light transmission path and memory utilizing optical bistability by changing the refractive index (double refraction) of waveguide by means of light. However, such element can not serve as an element with plasticity. And it is difficult to employ the element practically due to the many problems such as need of synthesis of a material having great non-linear optical effect and integration of the elements. Although a second-harmonic generation using asymmetric hetero LB films of polar pigment molecules and a tertiary non-linear optical effect using polydiacethylene are also studied, it is difficult to control the functions by light when using such LB films.

An object of the present invention is to solve the problems mentioned above and to provide an organic optical element applicable to optical memory element with plasticity, display element, optical shutter, optical memory and optical arithmetic element.

The organic optical element according to the present invention comprises an organic thin film comprising a photosensitive molecule film and an organic molecule film having an effect to receive electric charges from the photosensitive molecule film, which is provided adjacent to the photosensitive molecule film, and means for controlling the charge-separated state formed by transfer of the charges generated by excitation of the photosensitive molecules to the organic molecules receiving the charges upon irradiation with light within wavelength range which is absorbed by the photosensitive molecules.

In the present invention, the organic molecule film having the effect to receive the charges is an acceptor molecule film and a donor molecule film each provided on one of the both sides of the photosensitive molecule film as well as an acceptor molecule film or a donor molecule film provided on one side of the film of the photosensitive molecule film. The acceptor molecules receive electrons, and the donor molecules receive positive holes.

With the elements of the present invention, an element with plasticity can be constructed because it is possible to control the charge-separated state caused by transfer of the charges.

This invention can be more fully understood from the following detailed description when taken in conjunction with the accompanying drawings, in which:

Fig. 1 shows a structure of the organic optical memory element in Example 1;

Fig. 2 shows a diagram representing the principle of the operation of the element of Example 1 based on the energy level of each film;

Fig. 3 shows the relationship between the bias voltage and the time elapsed until the element of Example 1 loses the memory completely;

Fig. 4 shows change on standing in $A/A_0$ of the element of Example 1 at the bias voltage of 0.5 V;

Fig. 5 shows the relationship between the temperature and the time elapsed until the element of Example 1 loses the memory completely at the bias voltage of 0.5 V;

Fig. 6 shows a structure of the organic optical memory element in Example 2;

Fig. 7 shows a diagram representing the principle of the operation of the element of Example 2 based on the energy level of each film;

Fig. 8 shows the relationship between the number of pulses irradiated and the time elapsed until the element of Example 2 loses the memory completely at the bias voltage of 0.5 V at a room temperature;

Fig. 9 shows the relationship between the bias voltage and the time elapsed until the element of Example 2 loses the memory completely;

Fig. 10 shows a structure of the organic optical memory element in Example 3;

Fig. 11 shows a structure of the organic optical memory element in Example 4;

Fig. 12 shows change on standing in increment in absorbance of the element of Example 4 at the bias voltage of 0.5 V;

Fig. 13 shows the relationship between the bias voltage and the time elapsed until the element of Example 4 loses the memory completely (recovery of the value of the absorbance before irradiation);

Fig. 14 shows a structure of the organic optical memory element in Example 5;

Fig. 15 shows a structure of the organic optical memory element in Example 6;

Fig. 16 shows change on standing in increment in electric conductivity of the element of Example 5 at the bias voltage of 0.5 V;

Fig. 17 shows the relationship between the bias voltage and the time elapsed until the element of Example 6 loses the memory completely (recovery of the value of the electric conductivity before irradiation);

Fig. 18 shows a structure of the organic optical memory element in Example 7;

Fig. 19 shows change on standing in difference in threshold voltage of the element of Example 7 at the bias voltage of 0.5 V;

Fig. 20 shows the relationship between the bias voltage and the time elapsed until the element of Example 7 loses the memory completely (recovery of the value of the threshold voltage before irradiation);

Fig. 21 shows the relationship between the bias voltage and the time elapsed until the element of Example 9 loses the memory completely;
Fig. 22 shows the relationship between the bias voltage and the time elapsed until the element of Example 10 loses the memory completely;
Fig. 23 shows a structure of the organic optical memory element in Example 15;
Fig. 24 shows a diagram representing the principle of the operation of the element of Example 15 based on the energy level of each film;
Fig. 25 shows the relationship between the bias voltage and the time elapsed until the element of Example 15 loses the memory completely;
Fig. 26 shows change on standing in $A/A_0$ of the element of Example 15 at the bias voltage of 0.5 V;
Fig. 27 shows the relationship between the temperature and the time elapsed until the element of Example 15 loses the memory completely at the bias voltage of 0.5 V;
Fig. 28 shows a structure of the organic optical memory element in Example 16;
Fig. 29 shows a diagram representing the principle of the operation of the element of Example 16 based on the energy level of each film;
Fig. 30 shows the relationship between the bias voltage and the time elapsed until the element of Example 16 loses the memory completely;
Fig. 31 shows the relationship between the temperature and the time elapsed until the element of Example 16 loses the memory completely at the bias voltage of 0.5 V;
Fig. 32 shows a structure of the organic optical memory element in Example 17;
Fig. 33 shows a diagram representing the principle of the operation of the element of Example 17 based on the energy level of each film;
Fig. 34 shows the relationship between the number of pulses irradiated and the time elapsed until the element of Example 17 loses the memory completely at the bias voltage of 0.5 V at a room temperature;
Fig. 35 shows a structure of the organic optical memory element in Example 18;
Fig. 36 shows a structure of the organic optical memory element in Example 19;
Fig. 37 shows change on standing in difference in threshold voltage of the element of Example 19 at the bias voltage of 0.5 V;
Fig. 38 shows the relationship between the bias voltage and the time elapsed until the element of Example 19 loses the memory completely (recovery of the value of the threshold voltage before irradiation);
Fig. 39 shows the relationship between the bias voltage and the time elapsed until the element of Example 21 loses the memory completely;
Fig. 40 shows the relationship between the bias voltage and the time elapsed until the element of Example 22 loses the memory completely;
Fig. 41 shows a structure of the organic optical element in Example 25;
Fig. 42 shows a diagram representing the principle of the operation of the element of Example 25 based on the energy level of each film;
Fig. 43 shows a structure of the organic optical element in Example 26;
Fig. 44 shows a structure of the organic optical element in Example 29;
Fig. 45 shows a structure of the organic optical memory element in Example 38;
Fig. 46 is a diagram of the clock pulse voltage applied to the element of Example 38;
Figs. 47 and 48 show structures of the organic optical memory element in Example 39;
Fig. 49 shows a structure of the organic optical memory element in Example 40;
Fig. 50 shows a structure of the organic optical element in Example 41;
Fig. 51 shows a structure of the organic optical element in Example 42; and
Fig. 52 shows a structure of the organic optical element in Example 45.

An organic optical memory element according to the present invention generally has a structure wherein a pair of electrodes are provided on the both sides of an organic thin film comprising successively a donor molecule film, a photosensitive molecule film and an acceptor molecule film, or an organic thin film comprising successively a photosensitive molecule film and a donor molecule film or a photosensitive molecule film and an acceptor molecule film. In such an element, it is preferable to provide an insulating film between the organic thin film and at least one electrode in order to prevent the flow of the electric charges once separated into the electrode or to prevent the injection of the charges from the electrode.

In the present invention, various molecules as listed below may be employed as donor molecules, acceptor molecules and photosensitive molecules.

Examples of the donor molecules are p-phenylenediamine, o-phenylenediamine, m-phenylenediamine, tetrathiafulvalene, diselenadithiafulvalene, tetraselenafulvalene, tetraselenotetracene, quinoline, acridine, ferrocene, benzidine, diaminopyrene, polydiacethylene, hydroquinone, dimethoxybenzene, diazobenzene,

phenothiazine and derivatives containing these skeletons.

Examples of the acceptor molecules are tetracyanoquinodimethane, benzoquinone, naphthoquinone, anthraquinone, dinitrobenzene, trinitrobenzene, tricyanobenzene, hexacyanobenzene, trinitrofulvalenone, chlorobenzoquinone, dichlorobenzoquinone, trichlorobenzoquinone, dichlorodicyanobenzoquinone, cyanobenzoquinone, dicyanobenzoquinone, tricyanobenzoquinone, N,N′-dicyanoquinonediimine, N,N′-disulfonylquinonediimine, N-carbonyl-N′-cyanoquinonediimine, N-carbonyl-N′-sulfonylquinonediimine, N-sulfonyl-N′-cyanoquinonediimine, N-sulfonylquinoneimine, N-cyanoquinoneimine, diethienylene copper complex and derivatives containing these skeletons.

Examples of the photosensitive molecules are various dyes such as phthalocyanine, metal phthalocyanine complex, porphyrin, metal porphyrin complex, perylene, pyrene, merocyanine dye, Rhodamine dye, squalium dye and the like.

Photosensitive molecules are preferable which have the absorption range not covering the absorption range of the donor and/or acceptor molecules constructing the element, especially of the donor and/or acceptor molecules in the film formed on one side of the photosensitive molecule film where light is irradiated. Two or more photosensitive molecule films, donor molecule films or acceptor molecule films may be laminated to form a multilayered film in the element. Two or more cycles of organic thin films each consisting of the photosensitive molecule film and at least one of the donor molecule film and the acceptor molecule film may be laminated. In such case, two or more types of photo sensitive molecules may be employed, or two or more types of the donor molecule and/or acceptor molecule may be employed.

In the present invention, each film may be formed by LB method, vacuum deposition or casting. The most excellent characteristics of the element can be obtained by using LB film. Substituent suitable to each method is introduced chemically to corresponding organic molecules. For example, hydrophobic and hydrophilic substituents are generally introduced to the skeletons of the donor, acceptor and photosensitive molecules in LB method.

In the element according to the present invention, the insulating film and electrode of at least one side are transparent. Although the transparent insulating film may be formed of inorganic or organic materials provided that uniform thin film can be formed, polymeric film formed by LB method is preferable. Examples of the transparent electrodes are ITO film and nesa film. The other electrode is not specifically limited, and may be any of inorganic (such as metals and semiconductors) and organic materials, and in a form of liquid or solid, with a solid electrode being preferable.

In the present invention, the light to be irradiated to excite the photosensitive molecules may be a continuous light or pulse light. Monochromatic light such as laser beam or a light having a broad range of the wave lengths may also be employed, with laser beam being preferable.

In the element according to the present invention, light of a wavelength range capable of being absorbed by the photosensitive molecules is irradiated in order to excite the electrons in the photosensitive molecules, whereby providing pairs of electrons and positive holes. In case of the element wherein the acceptor and donor molecule films are provided on both sides of the photosensitive molecule film, the electrons are transferred to adjacent acceptor molecules and the positive holes are transferred to adjacent donor molecules. As a result, a charge-separated state is established, whereby completing the writing. In the element wherein the photosensitive film and the donor film are successively provided, the excited electrons are transferred to the electrode and the positive holes are transferred to the donor molecules when the electric potential of the electrode on the side of the photosensitive film is lower than lowest unoccupied molecular orbit (LUMO) of the photosensitive molecules. In the element wherein the photosensitive film and the acceptor film are successively provided, the excited electrons are transferred to the acceptor molecules and the positive holes are transferred to the electrode when the electric potential of the electrode on the side of the photosensitive film is higher than highest occupied molecular orbit (HOMO) of the photosensitive molecules. As a result, a charge-separated state is established, whereby completing the writing.

In the present invention, examples of means for controlling the charge-separated state established by transfer of the electrons and the positive holes are a power supply to apply the electric field in the thickness-wise direction of the organic thin film, a heating/cooling means to control the temperature of the organic thin film (e.g. Peltier element) and a light source to irradiate the light of a predetermined wavelength to the organic thin film.

The time required to recombine the electrons with the holes is generally longer when ionization potential of the donor molecule is lower and electron affinity of the acceptor molecule is higher. Therefore, by suitably selecting the skeleton of the donor and acceptor molecules and the substituents to be introduced, the time for recombination can be set as desired. For example, in the element wherein the acceptor and donor molecule films are provided on both sides of the photosensitive molecule film, the electrons and the holes can be separated into the acceptor and the donor films which sandwiches the photosensitive film. Accordingly, the distance

between the electrons and the holes may be longer than 2 nm whereby enabling the prolonged time required to recombine the electrons and the holes even after the irradiation with light is ceased.

The time for recombination of the charges can be varied by changing the electric field applied to the organic thin film. A longer time can be obtained by applying the field in the direction advantageous to the charge separation, and a shorter time can be obtained by applying the field in the reverse direction. The time for recombination of the charges can also be varied by changing the temperature. Thus, the lower the temperature, the longer the time. Furthermore, the time for recombination of the charges can be varied by changing the number of pulses irradiated or the period of the irradiation of the continuous light. Namely, the irradiation with light is proceeded, the time for recombination becomes longer. Especially in case of the structure wherein two or more donor or acceptor films are laminated, when the irradiation is proceeded, internal electric field causes the charges once separated by the initial irradiation to be transferred to further adjacent donor or acceptor film. As a result, the distance between the electrons and the holes becomes further longer, whereby requiring the further longer time for the recombination.

Further, when two or more cycles of organic thin films are laminated consisting of a donor molecule film, a photosensitive molecule film and an acceptor molecule film, consisting of a photosensitive molecule film and a donor molecule film, or consisting of a photosensitive molecule film and an acceptor molecule film, and two or more types of photosensitive molecules are used, two or more writing lights having different wavelengths can be used. Also without such lamination of two or more cycles of organic thin films, same effect can be obtained by using as a photosensitive molecule film a composite film consisting of two or more types of photosensitive molecules. When using two or more types of donor and acceptor molecules, memories to be kept for a long period and for a short period can be present at the same time. By using such structures, a multivalued memory can be realized.

As mentioned above, an optical memory element according to the present invention enables the storage time (time for recombination of the charges) to be controlled by means of electric field, temperature and irradiation with light. Accordingly, it can be used as an optical memory element with plasticity whose storage time can be controlled by the electrode potential (electric field) or temperature if the charge-separated state is detected and the relationship between the charge-separated state and parameters for control is known.

In the element of the present invention, the charge-separated state can be detected by various methods as mentioned below, and by using these method the memory can be read.

(a) Method of detecting the absorption wavelength which is newly generated upon ionization of the donor or acceptor molecules by an optical apparatus: In this case, a light source of the wavelength different from that of the writing light source is employed.

(b) Method of measuring the conductivity increased upon ionization of the donor and acceptor molecules along the surface of the film: The organic thin film without electron transfer is almost an insulator. On the other hand, when the transfer is caused, carriers can move freely between the donor or acceptor molecules, resulting in a significant increase in the conductivity. The conductivity is a physical parameter which exhibits the greatest change, and is one of the parameters capable of being determined at a highest accuracy. In this case, higher accuracy can be obtained by determining the conductivity rather widthwise on the surface of the film than thickness-wise. For this purpose, a pair of electrodes is provided on the perpendicular sides of the organic thin film.

(c) Method of measuring change in threshold voltage for switching of a field effect transistor in which an organic thin film of the present invention is formed at the gate region, where threshold voltage is affected by charge separation.

(d) Method of measuring transient current when voltage to cause the recombination of the charges is applied: In this case, the transient current is greater in the charge-separated state than in the state without charge separation. By this method, however, the memory is lost simultaneously with reading.

(e) Method of measuring transient current observed upon the irradiation of low energy reading light after the charge separation is caused by irradiating the high energy writing light : In this case, the transient current is suppressed when there is an internal field due to the charge separation.

Further, a higher integration of the elements is realized if one of the electrodes consisting of a group of microelectrodes is provided and the separated charges are transferred by application of clock pulse voltage to each electrode, because there is no need to provide a means to read the separated charges on each electrode. In such structure, when the time for recombination of the charges is prolonged as mentioned above, it is possible to prepare an element with plasticity whose storage time can be controlled by the electric field or temperature. On the other hand, when time for recombination is shortened and the element is used similarly as in standard CCD, it is possible to prepare a realtime image pickup element. Also, when two or more cycles of organic thin films are laminated and two or more types of photosensitive molecules are used, it is possible to use two or more writing lights having different wavelengths. Therefore, by using the photosensitive molecules corresponding to optical trichromatic colors, it is possible to prepare a high density color image pickup element without color filter.

According to the organic optical element of the present invention, characteristics of other functional organic molecules can be controlled. Examples of other functional organic molecules are liquid crystal molecules and molecules having non-linear optical effect.

For example, an element comprising an organic thin film consisting of a donor molecule film, a photosensitive molecule film and an acceptor molecule film, consisting of a photosensitive molecule film and a donor molecule film, or consisting of a photosensitive molecule film and an acceptor molecule film, a liquid crystal orientation film to control the pretilt angle of liquid crystal molecules, and a liquid crystal layer, which are sandwiched by electrodes can be constructed. Noted that the organic thin film itself may serve as an orientation film for some of the types of the liquid crystals. The liquid crystal molecules are not specifically limited, and ferroelectric liquid crystals and TN liquid crystals may be employed. Preferable orientation film is a polymer film formed by LB method.

The charge-separated state is also formed in such element by exciting the electrons in the photosensitive molecules upon irradiation with the light within the wavelength range capable of being absorbed by the photosensitive molecules to generate pairs of electrons and holes. Increased intensity of the exciting light provides increased internal electric field. Since the orientation of the liquid crystal molecules is caused at a certain threshold electric field, there is a threshold intensity of the exciting light. Accordingly, exciting light is used for ON/OFF of the light passing through the liquid crystal layer, whereby enabling optical switching. In this case, the transmitting light may be the same to or different from the exciting light of the photosensitive molecules. When a ferroelectric liquid crystal is employed, the difference in threshold is observed as a hysteresis between the exciting light while being increased and being decreased.

In this element, the threshold intensity of the exciting light can be varied by changing the structure of the organic thin film or the types of photosensitive, donor and acceptor molecules, or by previously applying a electric field below the threshold to the organic thin film and liquid crystal film. By using such threshold-controlling function, logic processing element such as AND, OR and NOT can be produced.

In addition, by changing the structure of the organic thin film, the time required to recombine the charges can be controlled when the irradiation of the exciting light is ceased. For example, when the structure wherein the photosensitive film is provided between the donor and acceptor films is employed, the distance is longer between the electrons and the holes separated from each other upon irradiation with exciting light, whereby requiring the longer time for recombination. On the other hand, when either of the donor or acceptor film is used together with the photosensitive film, the distance between the separated charges is short, resulting in short time for recombination. When using a ferroelectric liquid crystal, the time for recombination is long due to the effect of the field caused by the orientation of the ferroelectric liquid crystal.

When the threshold-controlling function and the memory function mentioned above are combined, elements having various functions can be produced. For example, it is possible to produce an element wherein the optical switch is ON when the threshold is exceeded at last after a predetermined number of pulses of a certain intensity has been irradiated. An optical neuroelement whose threshold is remained reduced for a while once it is irradiated (i.e. learning) can also be produced.

Similarly, it is possible to produce an element wherein a layer containing organic molecules having non-linear optical effect is provided close to the organic thin film. Also, the organic thin film can be directly imparted non-linear optical effect by using any of photosensitive molecules, donor molecules or acceptor molecules having non-linear optical effect, or by mixing organic molecules having non-linear optical effect with the photosensitive molecules, acceptor molecules or donor molecules. In such elements, by controlling the charge-separated state, the optical characteristics such as refractive index, reflectance and frequency modulating capacity, of the organic molecules having non-linear optical effect, can be controlled. Accordingly, by controlling such characteristics, ON/OFF of the light, switching of the transmission path and optical memory can be realized.

## Examples

The present invention is further described in the following examples with referring to the appended figures.

### Example 1

Figure 1 shows a structure of the organic optical memory element of this example. On glass substrate 1, Nesa film 2 having a thickness of 20 nm, $SiO_2$ film 3 having a thickness of 40 nm, acceptor molecule film 4, photosensitive molecule film 5, donor molecule film 6, insulating molecule film 7, and $A\ell$ electrode 8 having a thickness of 50 nm are successively formed.

This element is produced as follows. Nesa film 2 and $SiO_2$ film 3 on glass substrate 1 are formed by sputtering method. Super-lattice structure consisting of acceptor molecule film 4, photosensitive molecule film 5, donor molecule film 6 and insulating molecule film 7 is formed by LB method as described below.

Commercial LB film forming apparatus of vertical draw-up type (Joyce Loebel: LB trough 2) is employed. As an aqueous phase, water purified by ion exchange resin is used at the temperature of 18°C. The surface of glass/Nesa/$SiO_2$ substrate is pretreated with dodecyltrichlorosilane to impart hydrophobic property.

As an acceptor molecule, cholanyl-TCNQ of formula (1) shown below is dissolved in toluene to obtain LB film developing solution of 0.5 mg/ml. The curve of surface pressure vs molecule-occupying area indicates that the molecules form a solid condensed film at 12 dyn/cm. The substrate is drawn from the gas phase down to the water and then drawn from the water up to the gas phase through the solid condensed film of cholanyl-TCNQ (1) at the rate of 2 mm/min to obtain acceptor molecule film 4 consisting of two-layered film (thickness of 3.6 nm) of cholanyl-TCNQ (1). Since these monomolecular films are laminated in Y type, two-layered monomolecular film forms a single unit layer. Thus, the distance between the units of TCNQ is about 2 nm which corresponds to two cholane skeletons.

Then, as a photosensitive molecule, copper phthalocyanine derivative of formula (2) shown below is dissolved in chloroform to obtain LB film developing solution of 0.2 mg/ml. The molecules form a solid condensed film at 13 dyn/cm. By the similar method as mentioned above, photosensitive film 5 consisting of two-layered film (thickness of 2.8 nm) of copper phthalocyanine derivative (2) is formed on the acceptor molecule film 4.

Subsequently, as a donor molecule, p-phenylenediamine derivative of formula (3) shown below is dissolved in toluene to obtain LB film developing solution of 0.5 mg/ml. The molecules form a solid condensed film at 25 dyn/cm. By the method similar as mentioned above, donor molecule film 6 consisting of two-layered film (thickness of 4.8 nm) of p-phenylenediamine derivative (3) is formed on the photosensitive molecule film 5. Since these monomolecular films are laminated in Y type, two-layered monomolecular film forms a single unit layer.

Subsequently, as an insulating molecule, polyisobutylmethacrylate having a molecular weight of 200,000 with the repeating unit of formula (4) shown below is dissolved in chloroform to obtain LB film developing solution of 0.2 mg/ml. The molecules form a solid condensed film at 13 dyn/cm. By the method similar as mentioned above, insulating film 7 consisting of 30-layered film (thickness of 33 nm) of polyisobutylmethacrylate is formed on the donor molecule film 6.

Aℓ electrode 8 is formed by vacuum deposition at 3 x $10^{-6}$ Torr after drying the super-lattice structure formed as mentioned above overnight under nitrogen stream.

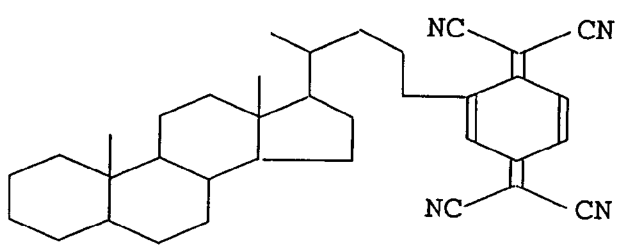

(1)

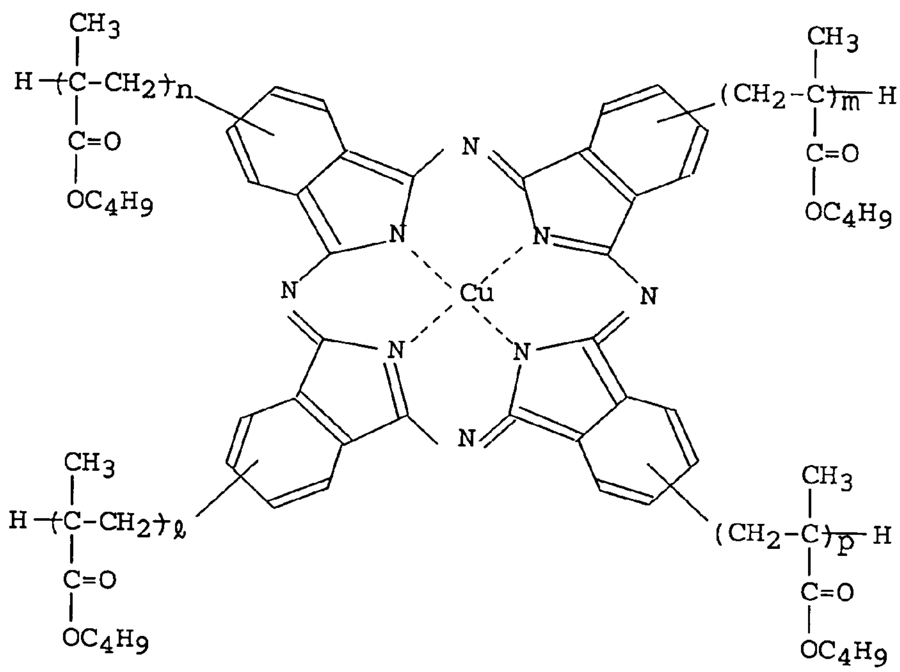

(2)

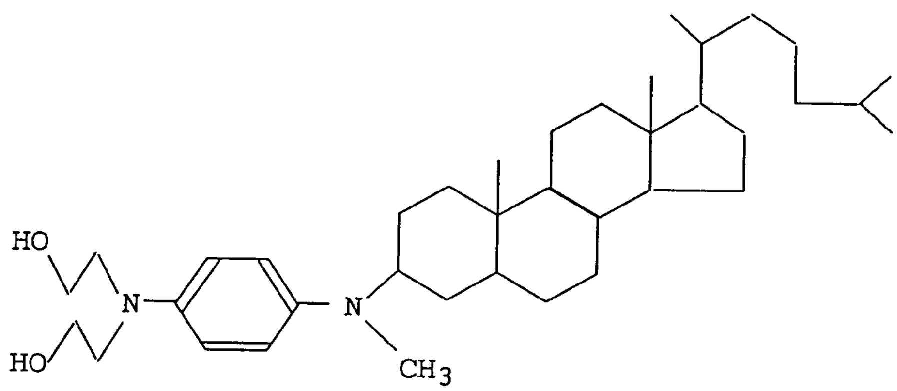

(3)

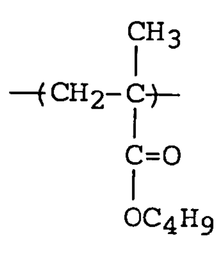

(4)

In the optical memory element in this example, copper phthalocyanine derivative (2) exhibits marked absorbance at 633 nm, while cholanyl-TCNQ (1), p-phenylenediamine derivative (3) and polyisobutylmethacrylate (4) do not exhibit absorbance.

With referring to Fig. 2 showing the energy level of each film of the element, the principle of writing on the element is briefly described below. The copper phthalocyanine derivative (photosensitive molecule) is excited by irradiation with light to generate pairs of electrons and holes, which are then transferred to LUMO of the cholanyl-TCNQ (acceptor molecule) and HOMO of the p-phenylenediamine derivative (donor molecule) respectively, whereby establishing the charge separation. The charge-separated state corresponds to information storage.

The charge-separated state can be detected by, for example, measuring transient current accompanying the irradiation with light, whereby enabling the reading of the memory. Thus, when comparing the transient current levels observed upon irradiation of a low energy reading light in the states with and without the charge separation, internal electric field present in the former state results in a current lower than that in the latter state.

More specifically, in the condition where bias voltage is applied with Nesa electrode 3 being positive, He-Ne laser beam (wavelength 633 nm, 5 mW, pulse interval 1 μsec, spot diameter 0.2 mm) is irradiated from the side of glass substrate 1 to effect writing. After allowing to stand at a room temperature in a dark place for a certain period, weak laser beam (0.5 mW) is irradiated to measure the transient current peak value (A). $A_0$ is defined herein as the peak value of the transient current when there is no charge separation.

Fig. 3 shows the relationship between the bias voltage and the time required for $A = A_0$, i.e. the time elapsed until the memory is completely lost. Fig. 4 shows change on standing in $A/A_0$ at the bias voltage of 0.5 V. Fig. 5 shows the relationship between the temperature and the time elapsed until the memory is lost completely when the temperature is controlled on Peltier element at the bias voltage of 0.5 V.

As evident from Figs. 3 to 5, an element wherein the period during which the memory is maintained can be controlled by means of voltage or temperature is obtained.

Example 2

Fig. 6 shows a structure of the organic optical memory element of this example. On glass substrate 1, Nesa film 2 having a thickness of 20 nm, $SiO_2$ film 3 having a thickness of 40 nm, three layers of acceptor molecule film 4, photosensitive molecule film 5, three layers of donor molecule film 6, insulating molecule film 7 and $A\ell$ electrode 8 having a thickness of 50 nm are successively formed.

This element is produced almost similarly as in Example 1. Super-lattice structure consisting of acceptor molecule film 4, photosensitive molecule film 5, donor molecule film 6 and insulating molecule film 7 is formed by LB method.

Six-layered monomolecular film of cholanyl-TCNQ (1) as an acceptor molecule is laminated to form three layers of acceptor molecule film 4. Since these monomolecular films are laminated in Y type, two-layered monomolecular film forms a single unit layer. Thus, the distance between the units of TCNQ is about 2 nm which corresponds to two cholane skeletons. Then photosensitive film 5 consisting of two-layered film of copper phthalocyanine derivative (2) is formed. Then, six-layered monomolecular film of p-phenylenediamine derivative (3) as a donor molecule is laminated to form three layers of donor molecule film 6. Subsequently, insulating molecule film 7 consisting of 30-layered film of polyisobutylmethacrylate (4) having a MW of 200,000 as an insulating molecule is formed.

With referring to Fig. 7 showing the energy level of each film of the element, the principle of writing on the element is briefly described below. The copper phthalocyanine derivative (photosensitive molecule) is excited by irradiation with light to generate pairs of electrons and holes, which are then transferred to LUMO of the cholanyl-TCNQ (acceptor molecule) and HOMO of the p-phenylenediamine derivative (donor molecule) respectively, whereby establishing the charge separation. When continuous light irradiation is further proceeded or pulse light is repeatedly irradiated, the electric charge separation further proceeds due to the internal electric field, and the charges are further transferred to the adjacent acceptor or donor molecules. As a result, the distance between electrons and holes becomes longer, giving a longer time required for recombination. In this case, even when a strong external field is applied instead of irradiation, the distance between the electrons and holes becomes longer similarly. Therefore, enhanced non-linear characteristics is obtained by the effect of the electric field comparing to that observed in Example 1.

Fig. 8 shows the relationship between the number of pulses irradiated and the time elapsed until the memory is lost completely at a room temperature and at the bias voltage of 0.5 V. As evident from Fig. 8, an element is obtained wherein the period during which the memory is maintained can be controlled by number of stimulation applied. Fig. 9 shows the relationship between the bias voltage and the time elapsed until the memory is lost completely at a room temperature.

Example 3

Fig. 10 shows a structure of the organic optical memory element of this example. On glass substrate 1, Nesa film 2 having a thickness of 20 nm, $SiO_2$ film 3 having a thickness of 40 nm, acceptor molecule film 4, photosensitive molecule film 5 containing photosensitive molecule $S_1$, donor molecule film 6, insulating molecule film 7, acceptor molecule film 4, photosensitive molecule film 9 containing photosensitive molecule

$S_2$, donor molecule film 6, insulating molecule film 7 and Aℓ electrode 8 having a thickness of 50 nm are successively formed.

The element is produced almost similarly as in Example 1. Super-lattice structure consisting of acceptor molecule film 4, photosensitive molecule film 5 containing photosensitive molecule $S_1$, donor molecule film 6, insulating molecule film 7, acceptor molecule film 4, photosensitive molecule film 9 containing photosensitive molecule $S_2$, donor molecule film 6, insulating molecule film 7 is made by LB method.

Acceptor molecule film 4 consisting of two-layered film of cholanyl-TCNQ (1), photosensitive molecule film 5 consisting of 2-layered film of copper phthalocyanine derivative (2), donor molecule film 6 consisting of two-layered film of p-phenylenediamine derivative (3), and insulating molecule layer 7 consisting of 10-layered film of polyisobutylmethacrylate (4) of the MW of 200,000 are successively formed. Then acceptor molecule film 4 consisting of two-layered film of cholanyl-TCNQ (1) is formed. Then, photosensitive molecule film 9 consisting of two-layered film of mixed monomolecular film of Ni phthalocyanine derivative of formula (5) and stearic acid in a molar ratio of 1 : 1 is formed. This mixed monomolecular film is formed at the surface pressure of 20 dyn/cm. Subsequently, donor molecule film 6 consisting of two-layered film of p-phenylenediamine derivative (3), and insulating molecule layer 7 consisting of 30-layered film of polyisobutylmethacrylate of the MW of 200,000 are formed successively.

In the optical memory element in this example, copper phthalocyanine derivative (2) exhibits absorbance at 633 nm, while it exhibits almost no absorbance at 830 nm which is a wavelength of near infrared semiconductor laser. On the other hand, Ni-phthalocyanine derivative (5) exhibits almost no absorbance at 633 nm, while it exhibits marked absorbance at 830 nm. Acceptor and donor molecules (1) and (2) do not exhibit absorbance at any of the both wavelengths.

Based on the results of the measurement of the transient current upon irradiation, it is confirmed that this element can serve as a two-valued memory element capable of processing independently the light at the two wavelengths described above. This indicates that further multivalued optical memory element can be constructed by selecting the wavelengths absorbed by photosensitive molecules.

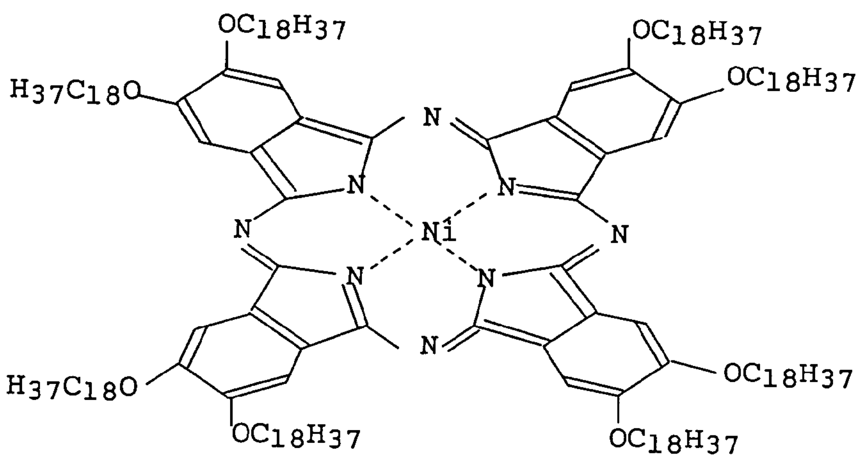

(5)

Example 4

Fig. 11 shows a structure of the organic optical memory element of this example. On glass substrate 1, Nesa film 2 having a thickness of 20 nm, $SiO_2$ film 3 having a thickness of 40 nm and 10 cycles of four-layered structure each consisting of acceptor molecule film 4, photosensitive molecule film 5, donor molecule film 6 and insulating molecule film 7 are formed, and semitransparent Au electrode 11 having a thickness of 50 nm is further provided.

The element is produced almost similarly as in Example 1. In this example, the memory is read by measuring absorbance at 500 nm upon ionization of a donor molecule (3). More specifically, in the condition where bias voltage is applied with Nesa electrode 3 being positive, He-Ne laser beam (wavelength 633 nm, 5 mW, pulse interval 1 μsec) is irradiated from the side of glass substrate 1 to effect writing. After allowing to stand at a room temperature in a dark place for a certain period, 500 nm spectral light from halogen lamp is irradiated to determine absorbance.

Fig. 12 shows change on standing in increment in absorbance at the bias voltage of 0.5 V. Fig. 13 shows the relationship between the bias voltage and the time elapsed until the memory is lost completely (recovery of the absorbance observed before irradiation).

Example 5

Fig. 14 shows a structure of the organic optical memory element of this example. On glass substrate 1, Nesa film 2 having a thickness of 20 nm, $SiO_2$ film 3 having a thickness of 40 nm, acceptor molecule film 4 containing acceptor molecule $A_1$, photosensitive molecule film 5 containing photosensitive molecule S, donor molecule film 6 containing donor molecule $D_1$, insulating molecule film 7, acceptor molecule film 4 containing acceptor molecule $A_2$, photosensitive molecule film 5 containing photosensitive molecule S, donor molecule film 6 containing donor molecule $D_2$, insulating molecule film 7, and Aℓ electrode 8 having a thickness of 50 nm are successively provided.

The element is produced almost similarly as in Example 1. Super-lattice structure consisting of acceptor molecule film 4 containing acceptor molecule $A_1$, photosensitive molecule film 5 containing photosensitive molecule S, donor molecule film 6 containing donor molecule D1, insulating molecule film 7, acceptor molecule film 4 containing acceptor molecule $A_2$, photosensitive molecule film 5 containing photosensitive molecule S, donor molecule film 6 containing donor molecule $D_2$ and insulating molecule film 7 is made by LB method.

Acceptor molecule film 4 consisting of two-layered film of cholanyl-TCNQ (1), photosensitive molecule film 5 consisting of two-layered film of copper phthalocyanine derivative (2), donor molecule film consisting of two-layered film of p-phenylenediamine derivative (3), and insulating molecule layer 7 consisting of ten-layered film of polyisobutylmethacrylate (4) of the MW of 200,000 are successively formed. Then photosensitive molecule film 4 consisting of two-layered film of acceptor molecule of formula (6) is formed. Then, photosensitive molecule film 5 consisting of two-layered film of copper phthalocyanine derivative (2) is formed. Then donor molecule film 6 consisting of two-layered film of donor molecule of formula (7) and insulating molecule film 7 consisting of 10-layered film of polyisobutylmethacrylate (4) of the MW of 200,000 are successively.

When change on standing in $A/A_0$ at the bias voltage of 0.5 V similarly as in Example 1, it is proved that the element has the memory characteristics for both of long and short memories at the same time.

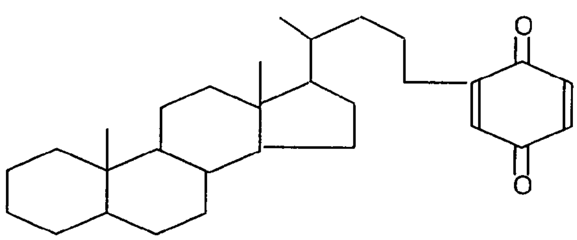

(6)

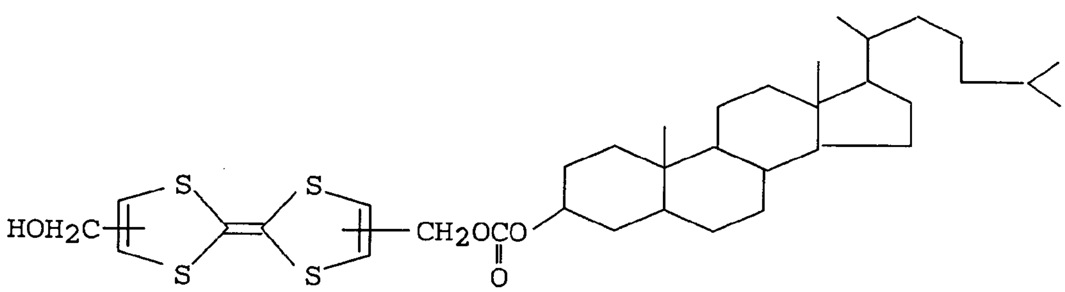

(7)

Example 6

Fig. 15 shows a structure of the organic optical memory element of this example. On glass substrate 1, Nesa film 2 having a thickness of 20 nm, $SiO_2$ film 3 having a thickness of 40 nm and 3 cycles of three-layered structure each consisting of acceptor molecule film 4, photosensitive molecule film 5 and donor molecule film 6 are formed. Both perpendicular sides of acceptor molecule film 4, photosensitive molecule 5 and donor molecule film 6, a pair of Au electrodes 12 is provided. Insulating molecule film 7 and Aℓ electrode 8 having a thickness of 50 nm are further provided.

The element is produced almost similarly as in Example 1, except for additional process for Au electrode 12 by vacuum deposition.

In this example, the memory is read by measuring the conductivity of the organic thin film along the surface of the film by a pair of Au electrodes 12. More specifically, in the condition where bias voltage is applied with Nesa electrode 3 being positive, He-Ne laser beam (wavelength 633 nm, 5 mW, pulse interval 1 μsec) is

irradiated from the side of glass substrate 1 to effect writing. After allowing to stand at a room temperature in a dark place for a certain period, the conductivity is determined by Au electrodes 12.

Fig. 16 shows change on standing in increment in conductivity at the bias voltage of 0.5 V. Fig. 17 shows the relationship between the bias voltage and the time elapsed until the memory is lost completely (recovery of the conductivity observed before irradiation).

Example 7

Fig. 18 shows a structure of the organic optical memory element of this example. On the surface of p type silicon substrate 21, n+-source and drain regions 22 and 23 are formed. On the channel region between source and drain regions 22 and 23, $SiO_2$ film 3 having a thickness of 20 nm, donor molecule film 6, photosensitive film 5, acceptor molecule film 4, insulating molecule film 7 and semi-transparent Au electrode 11 as a gate electrode are formed successively. On source and drain regions 22 and 23, source and drain electrodes 24 and 25 are formed, respectively.

The element is produced almost similarly as in Example 1 except for using silicon substrate 21.

In this example, the memory is read by measuring the threshold gate voltage for switching of the field effect transistor. More specifically, in the condition where bias voltage is applied with Au electrode 11 as a gate electrode being positive, He-Ne laser beam (wavelength 633 nm, 5 mW, pulse interval 1 μsec.) is irradiated from the side of Au electrode 11 to effect writing. After allowing to stand at a room temperature in a dark place for a certain period, the threshold voltage is determined.

Fig. 19 shows change on standing in difference in threshold voltage at the bias voltage of 0.5 V. Fig. 20 shows the relationship between the bias voltage and the time elapsed until the memory is completely lost (recovery of the threshold voltage observed before irradiation).

Example 8

The element is evaluated for the characteristics of an optical memory element similarly as in Example 1 except for using halogen lamp whose wavelengths of 500 nm or less are cut instead of He-Ne laser beam. Also in this case, an optical memory element with plasticity is obtained wherein the period during which the memory is maintained can be easily controlled by voltage or temperature.

Example 9

The element is produced and evaluated for the operation similarly as in Example 1 except for using acceptor molecule of formula (8) shown below instead of acceptor molecule (1).

Fig. 21 shows the relationship between the bias voltage and the time elapsed until the memory is completely lost. Also in this case, an optical memory element with plasticity is obtained wherein the period during which memory is maintained can easily be controlled.

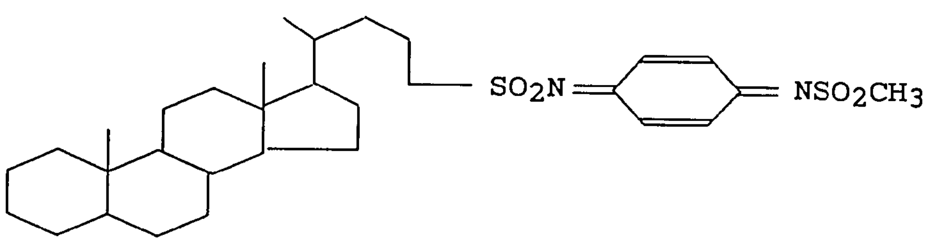

(8)

Example 10

The element is produced and evaluated for the operation similarly as in Example 1 except for using acceptor molecule of formula (6) shown above instead of acceptor molecule (1).

Fig. 22 shows the relationship between the bias voltage and the time elapsed until the memory is completely lost. Also in this case, an optical memory element with plasticity is obtained wherein the period during which memory is maintained can easily be controlled.

Example 11

The element is produced and evaluated for the operation similarly as in Example 1 except for using donor molecule of formula (7) shown above instead of donor molecule (3). Also in this case, an optical memory element with plasticity is obtained wherein the period during which memory is maintained can easily be controlled.

Example 12

The element is produced and evaluated for the operation similarly as in Example 1 except for using donor molecule of formula (9) shown below instead of donor molecule (3). Also in this case, an optical memory element with plasticity is obtained wherein the period during which memory is maintained can easily be controlled.

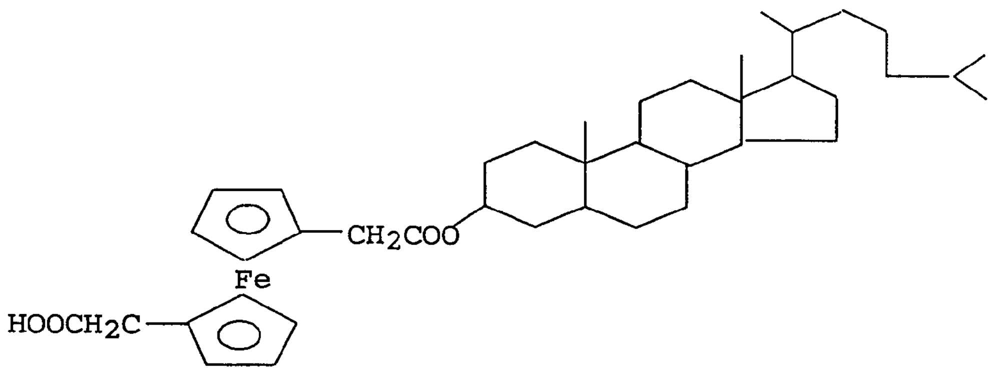

(9)

Example 13

The element is produced and evaluated for the operation similarly as in Example 1 except for using donor molecule of formula (7) instead of donor molecule (3) and acceptor molecule (8) instead of acceptor molecule (1). Also in this case, an optical memory element with plasticity is obtained wherein the period during which memory is maintained can easily be con trolled.

Example 14

The element is produced and evaluated for the operation similarly as in Example 1 except for using the film made from the mixture of photosensitive molecules (2) and (5) instead of the film made only from photosensitive molecule (2). In this case, an optical memory element with plasticity is obtained wherein writing can be conducted by using two lights having different wavelength and the period during which memory is maintained can easily be controlled.

Example 15

Fig. 23 shows a structure of the organic optical memory element of this example. On glass substrate 1, ITO film 13 having a thickness of 20 nm, photosensitive molecule film 5, donor molecule film 6, insulating molecule film 7, and $A\ell$ electrode 8 having a thickness of 50 nm are successively formed.

This element is produced as follows, ITO film 13 on glass substrate 1 is formed by sputtering method. Super-lattice structure consisting of photosensitive molecule film 5, donor molecule film 6 and insulating molecule film 7 is formed by LB method as described below.

Commercial LB film forming apparatus of vertical draw-up type is employed. As an aqueous phase, water purified by ion exchange resin is used at the temperature of 18°C. The surface of glass/ITO substrate is washed with acetone, chloroform, acetone and purified water.

As a photosensitive molecule, copper phthalocyanine derivative of formula (2) is dissolved in chloroform to obtain LB film developing solution of 0.2 mg/ml. The molecules form a solid condensed film at 13 dyn/cm. The substrate is drawn from the water up to the gas phase, drawn down and then drawn up again through the solid condensed film of copper phthalocyanine derivative (2) at the rate of 5 mm/min to obtain photosensitive molecule film 5 consisting of three-layered film of copper phthalocyanine derivative (2).

Then, as a donor molecule, p-phenylenediamine derivative of formula (3) is dissolved in toluene to obtain

LB film developing solution of 0.5 mg/ml. The molecules form a solid condensed film at 25 dyn/cm. By the method mentioned above, donor molecule film 6 consisting of two-layered film of p-phenylenediamine derivative (3) is formed on the photosensitive molecule film 5.

Subsequently, as an insulating molecule, polyisobutylmethacrylate having a molecular weight of 200,000 with the repeating unit of formula (4) is dissolved in chloroform to obtain LB film developing solution of 0.2 mg/ml. The molecules form a solid condensed film at 13 dyn/cm. By the method mentioned above, insulating film 7 consisting of 30-layered film of polyisobutylmethacrylate (4) is formed on the donor molecule film 6.

Aℓ electrode 8 is formed by vacuum deposition at $3 \times 10^{-6}$ Torr after drying the super-lattice structure formed as mentioned above overnight under nitrogen stream.

In the optical memory element in this example, copper phthalocyanine derivative (2) exhibits marked absorbance at 600 to 640 nm, while p-phenylenediamine derivative (3) and polyisobutylmethacrylate (4) do not exhibit absorbance.

With referring to Fig. 24 showing the energy level of each film of the element, the principle of writing on the element is briefly described below. The copper phthalocyanine derivative (photosensitive molecule) is excited by irradiation with light to generate pairs of electrons and holes, which are then transferred to ITO electrode and HOMO of the p-phenylenediamine derivative (donor molecule) respectively, whereby establishing the charge separation. The state wherein the charges are accumulated in the donor molecule film corresponds to information storage.

The charge-separated state can be detected by, for example, measuring transient current accompanying the irradiation with light, whereby enabling the reading of the memory. Thus, when comparing the transient current levels observed upon irradiation of a low energy reading light in the states with and without the charge separation, internal electric field present in the former state results in a current lower than that in the latter state.

More specifically, in the condition where bias voltage is applied with ITO electrode 13 being positive, He-Ne laser beam (wavelength 633 nm, 5 mW, pulse interval 1 μsec, spot diameter 0.2 mm) is irradiated from the side of glass substrate 1 to effect writing. After allowing to stand at a room temperature in a dark place for a certain period, weak laser beam (0.5 mW) is irradiated to determine the transient current peak value (A). $A_0$ is defined herein as the peak value of the transient current when there is no charge separation.

Figure 25 shows the relationship between the bias voltage and the time required for $A = A_0$, i.e. the time elapsed until the memory is completely lost. Fig. 26 shows change on standing in $A/A_0$ at the bias voltage of 0.5 V. Fig. 27 shows the relationship between the temperature and the time elapsed until the memory is lost completely at the bias voltage of 0.5 V.

As evident from Figs. 25 to 27, an element is obtained wherein the period during which the memory is maintained can be controlled by means of voltage or temperature.

Example 16

Fig. 28 shows a structure of the organic optical memory element of this example. On glass substrate 1, ITO film 13 having a thickness of 20 nm, photosensitive molecule film 5, acceptor molecule film 4, insulating molecule film 7, and Aℓ electrode 8 having a thickness of 50 nm are successively formed.

The element is produced almost similarly as in Example 15 except for using cholanyl-TCNQ (1) as an acceptor molecule instead of p-phenylenediamine derivative (3) as a donor molecule. In this example, cholanyl TCNQ (1) is dissolved in toluene to LB film developing solution of 0.2 mg/ml of. The molecules form a solid condensed film at 13 dyn/cm.

With referring to Fig. 29 showing the energy level of each film of the element, the principle of writing on the element is briefly described below. The copper phthalocyanine derivative (photosensitive molecule) is excited by irradiation with light to generate pairs of electrons and holes, which are then transferred to LUMO of adjacent cholanyl-TCNQ (acceptor molecule) and ITO electrode, respectively, whereby establishing the charge separation. The state wherein the charges are accumulated in the acceptor molecule film corresponds to information storage.

Fig. 30 shows the relationship between the bias voltage and the time elapsed the memory is completely lost at a room temperature. Fig. 31 shows the relationship between the temperature and the time elapsed until the memory is completely lost at the bias voltage of 0.5 V.

As evident from Figs. 30 and 31, an element is obtained wherein the period during which the memory is maintained can be controlled by means of voltage or temperature.

Example 17

Fig. 32 shows a structure of the organic optical memory element of this example. On glass substrate 1,

ITO film 13 having a thickness of 20 nm, photosensitive molecule film 5, donor molecule film 6, insulating molecule film 7, and Aℓ electrode 8 having a thickness of 50 nm are successively formed.

Instead of the two-layered film of p-phenylenediamine derivative (3) as donor molecule film 6 in Example 15, six-layered film of p-phenylenediamine derivative (3) is employed in this example as donor molecule film 6. Since films of p-phenylenediamine derivative (3) are laminated in Y type, two-layered film serves as a unit layer of donor molecule film. Therefore, six-layered film corresponded to three layers of donor molecule film.

With referring to Fig. 33 showing the energy level of each film of the element, the principle of writing on the element is briefly described below. The copper phthalocyanine derivative (photosensitive molecule) is excited by irradiation with light to generate pairs of electrons and holes, which are then transferred to ITO electrode and HOMO of the p-phenylenediamine derivative (donor molecule), respectively, whereby establishing the charge separation. The state wherein the charges are accumulated in the donor molecule film corresponds to information storage. When continuous light irradiation is further proceeded or pulse light is repeatedly irradiated, the electric charges are further transferred to adjacent donor molecule films due to the internal electric field. As a result, the distance between ITO film and holes accumulated in the donor molecule film becomes longer, giving a longer memory-maintaining period when compared with that in Example 15.

Fig. 34 shows the relationship between the number of pulses irradiated and the time elapsed until the memory is completely lost at the bias voltage of 0.5 V at a room temperature. As evident from Fig. 34, an element is obtained wherein the period during which the memory is maintained can be controlled by means of number of stimulation.

Example 18

Fig. 35 shows a structure of the organic optical memory element of this example. On glass substrate 1, ITO film 13 having a thickness of 20 nm, photosensitive molecule film 5, donor molecule film 6, insulating molecule film 7, and Aℓ electrode 8 having a thickness of 50 nm are successively formed.

In this example, photosensitive molecule 5 is made from the mixture of copper phthalocyanine derivative (2) $S_1$ and Ni phthalocyanine derivative (5) $S_2$ (in equal molar ratio as phthalocyanine skeletons).

Copper phthalocyanine derivative (2) exhibits absorbance at 633 nm, while it exhibits almost no absorbance at 830 nm which is the wavelength of near infrared semiconductor laser. On the other hand, Ni phthalocyanine derivative (5) exhibits no absorbance at 633 nm, while it exhibits marked absorbance at 830 nm. p-Phenylenediamine (donor molecule) does not exhibit absorbance at any of the both wavelengths.

Based on the results of the measurement of the transient current accompanying irradiation, it is confirmed that this element can serve as a two-valued memory element capable of independently processing the lights at the two wavelengths. This indicates that further multivalued optical memory element can be constructed by selecting the wavelengths absorbed by photosensitive molecules.

Example 19

Fig. 36 shows a structure of the organic optical memory element of this example. On the surface of p type silicon substrate 21, n+-source and drain regions 22 and 23 are formed. On the channel region between source and drain regions 22 and 23, $SiO_2$ film 3 having a thickness of 20 nm, donor molecule film 6, photosensitive film 5 and semi-transparent Au electrode 11 as a gate electrode are formed successively. On source and drain regions 22 and 23, source and drain electrodes 26 and 27 are formed, respectively.

The element is made almost similarly as in Example 15 except for using silicon substrate 21.

In this example, the memory is read by measuring the threshold gate voltage for the switching of the field effect transistor. More specifically, in the condition where bias voltage is applied with Au electrode 11 as a gate electrode being positive, He-Ne laser beam (wavelength 633 nm, 5 mW, pulse interval 1 μsec.) is irradiated from the side of semitransparent Au electrode 11 to effect writing. After allowing to stand at a room temperature in a dark place for a certain period, the threshold voltage is determined.

Fig. 37 shows the change on standing in difference in threshold voltage at the bias voltage of 0.5 V. Fig. 38 shows the relationship between the bias voltage and the time elapsed until the memory is completely lost (recovery of the threshold voltage observed before irradiation).

Example 20

The element is evaluated for the characteristics of an optical memory element similarly as in Example 15 except for using halogen lamp whose wavelengths of 500 nm or less are cut instead of He-Ne laser beam. Also in this case, an optical memory element with plasticity is obtained wherein the period during which the memory

is maintained can easily be controlled by voltage or temperature similarly as in Example 15.

Example 21

The element is produced and evaluated for the operation similarly as in Example 15 except for using acceptor molecule of formula (8) instead of acceptor molecule (1).

Fig. 39 shows the relationship between the bias voltage and the time elapsed until the memory is completely lost. Also in this case, an optical memory element with plasticity is obtained whose memory-maintaining period can easily be controlled.

Example 22

The element is produced and evaluated for the operation similarly as in Example 16 except for using acceptor molecule of formula (6) instead of acceptor molecule (1).

Fig. 40 shows the relationship between the bias voltage and the time elapsed until the memory is completely lost. Also in this case, an optical memory element with plasticity whose memory-maintaining period can easily be controlled is obtained.

Example 23

The element is produced and evaluated for the operation similarly as in Example 15 except for using donor molecule of formula (7) instead of donor molecule (3). Also in this case, an optical memory element with plasticity is obtained whose memory-maintaining period can easily be controlled.

Example 24

The element is produced and evaluated for the operation similarly as in Example 15 except for using donor molecule of formula (9) instead of donor molecule (3). Also in this case, an optical memory element with plasticity is obtained whose memory-maintaining period can easily be controlled.

Example 25

Fig. 41 shows a structure of the organic optical element of this example. On one glass substrate 1, ITO film 13 having a thickness of 20 nm and $SiO_2$ film 3 having a thickness of 10 nm are formed. On $SiO_2$ film 3, three cycles of acceptor molecule film 4 and photosensitive molecule film 5 are laminated to form a super-lattice structure. On this super-lattice structure, insulating molecule film 14 which also served as a liquid crystal orientation film is provided. On the other glass substrate 1, ITO film 13 having a thickness of 20 nm and insulating molecule film 14 which also served as a liquid crystal orientation film are provided. Both glass substrates 1, 1 are sealed to each other by sealant 15 via spacer (not indicated) with insulating/liquid crystal orienting films 14, 14 being inside, and liquid crystal molecule layer 16 is formed between the substrates.

This element is produced as follows. ITO film 13 and $SiO_2$ film 3 on glass substrate 1 are formed by sputtering method. Acceptor molecule film 4 and photosensitive molecule film 5 are formed by LB method as described below.

Commercial LB film forming apparatus of vertical draw-up type is employed. As an aqueous phase, water purified by ion exchange resin is used at the temperature of 18°C. The surface of glass/ITO/$SiO_2$ substrate is pretreated with dodecyltrichlorosilane to impart hydrophobic property.

As an acceptor molecule, cholanyl-TCNQ (1) is dissolved in toluene to obtain LB film developing solution of 0.5 mg/ml. The curve of surface pressure vs molecule-occupying area indicates that the molecules form a solid condensed film at 12 dyn/cm. The substrate is drawn from the gas phase down to the water and then drawn from the water up to the gas phase through the solid condensed film of cholanyl-TCNQ (1) at the rate of 2 mm/min to obtain acceptor molecule film 4 consisting of two-layered film of cholanyl-TCNQ (1).

Then, as a photosensitive molecule, copper phthalocyanine derivative (2) is dissolved in chloroform to obtain LB film developing solution of 0.2 mg/ml. The molecules form a solid condensed film at 13 dyn/cm. By the similar method as mentioned above, photosensitive film 5 consisting of two-layered film of copper phthalocyanine derivative (2) is formed on acceptor molecule film 4. The above procedure is repeated to obtain three cycles of the super-lattice structure.

Subsequently, trimethylsilylcyanoethylcellulose of formula (10) is dissolved in cyclohexanone to obtain LB film developing solution of 0.2 mg/ml. The molecules form a solid condensed film at 7 dyn/cm. By the method

similar as mentioned above, seven-layered insulating/ liquid crystal orientation film 14 is formed. Similarly, on the other glass/ITO substrate, the insulating/liquid crystal orientation film 14 is formed.

Finally, sealant is used to form a liquid crystal element, into which ferroelectric liquid crystal (Chisso, trade name CS1011) is injected to form liquid crystal molecule layer 15, and then the injection site is closed.

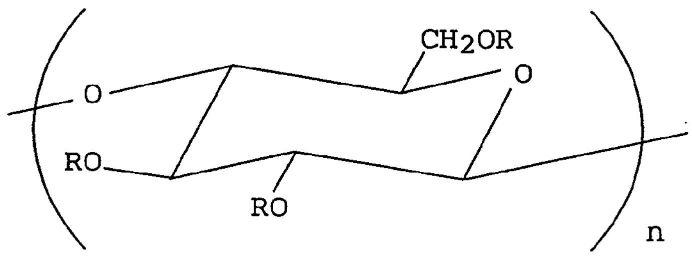

(10)

(R is H, $CH_2CH_2CN$ or $Si(CH_3)_3$, n is integer)

When rotating the organic optical element thus obtained while being sandwiched between two polarizing plates, conversion between light and dark is observed at the angle of every 45 degree, indicating the orientation of the ferroelectric liquid crystal molecules.

In the optical element in this example, copper phthalocyanine derivative (2) exhibits marked absorbance at 633 nm, while cholanyl-TCNQ (1) and trimethylsilylcyanoethylcellulose (10) do not exhibit absorbance.

With referring to Fig. 42 showing the energy level of each film of the element, the principle of operation of the element is briefly described below. The electrons in copper phthalocyanine derivative (photosensitive molecule) are excited by irradiation with light, which are then transferred to LUMO of cholanyl-TCNQ (acceptor molecule), whereby establishing the internal electric field due to the charge separation. The degree of charge separation is increased along with the increase in the intensity of the irradiation. When the intensity reaches to a certain level, the internal electric field exceeds the threshold field at which the liquid crystal molecules are oriented, whereby causing the liquid crystal molecule layer to become transparent. As a result, intensity of the transmittance is rapidly increased to effect optical switching.

More specifically, in the condition where the bias voltage is applied with ITO electrode 2 lower in the figure being positive, He-Ne laser beam (wavelength 633 nm, spot diameter 5 mm) is irradiated from the side of glass substrate 1 lower in the figure.

At the bias voltage is 8 V, transmitting light intensity is rapidly increased once the laser intensity has reached to 0.5 $mW/cm^2$. At the bias voltage of 9 V, the threshold of the laser intensity is 0.2 $W/cm^2$. Thus, it is indicated that the threshold varied depending on bias voltage.

Based on this finding, two laser beams are employed at the intensity of 0.3 $mW/cm^2$ to conduct the experiment similar as mentioned above. At the bias voltage of 8 V, transmitting light intensity is increased rapidly when two laser beams are used, while it is not increased when one beam is irradiated. At the bias voltage of 9 V, transmitting light intensity is increased rapidly even when one beam is irradiated. Accordingly, it is indicated that the element can be used for logic processing of AND at the bias voltage of 8 V and OR at the bias voltage of 9 V.

Example 26

Fig. 43 shows a structure of the organic optical element of this example. On one glass substrate 1, ITO film 13 having a thickness of 20 nm and $SiO_2$ film 3 having a thickness of 10 nm are formed. On $SiO_2$ film 3, three cycles of acceptor molecule film 4, photosensitive molecule film 5 and donor molecule film 6 are laminated to form a super-lattice structure. On this super-lattice structure, insulating molecule film 14 which also served as a liquid crystal orientation film is provided. On the other glass substrate 1, ITO film 13 having a thickness of 20 nm and insulating molecule film 14 which also served as a liquid crystal orientation film are provided. Both glass substrates 1, 1 are sealed to each other by sealant 15 via spacer (not indicated) with insulating/liquid crystal orientation films 14, 14 being inside, liquid crystal molecule layer 16 is formed between the substrates.

The element is produced almost similarly as in Example 25. The super-lattice structure consisting of acceptor molecule film 4, photosensitive molecule film 5, donor molecule film 6 and insulating/liquid crystal orientation film 14 is formed by LB method. In this example, as a donor molecule, p-phenylenediamine derivative (3) is dissolved in toluene to form LB film developing solution of 0.5 mg/ml. The molecules form a solid condensed film at 25 dyn/cm.

Since the photosensitive molecule film in this element is sandwiched between the acceptor molecule film

and the donor molecule film, it takes a longer time for recombination of the separated charges, whereby effecting as a memory. In fact, when the He-Ne laser beam (wavelength 633 nm) is irradiated at the bias voltage of 8 V, the intensity of transmitting light of 550 nm is increased rapidly once the laser intensity has reached to 0.5 $mW/cm^2$, and the light transmittance is observed about 10 minutes even after the termination of the laser irradiation. The light of 550 nm is hardly absorbed by the organic thin film of this example, and exhibits no effect on the orientation of the liquid crystal. The storage time is prolonged at the lower temperature. When laser beam is irradiated again 12 minutes after termination of the irradiation, it is indicated that the threshold is decreased to 0.4 $mW/cm^2$.

Then the laser beam of 3 $mW/cm^2$ is irradiated as pulses with the irradiation time of 0.1 second at the interval of 1 second. As a result, it is indicated that the threshold is exceeded by irradiating 4 pulses.

Example 27

The element similar to that in Example 25 is produced except for changing the order of lamination of the acceptor molecule film and the photosensitive molecule film. At the bias voltage of 10 V, the element becomes transparent. When the element is irradiated with the laser beam of 2 $mW/cm^2$, it turns into opaque due to the electric field generated in the reverse direction.

Example 28

The element similar to that in Example 25 is made except for using six cycles of the acceptor molecule films and the photosensitive molecule films. At the bias voltage of 8 V, the transmitting light intensity is rapidly increased once He-Ne laser intensity reached to 0.35 $mW/cm^2$. Thus, the threshold of the exciting beam intensity can be varied by changing the number of cycles of the lamination.

Example 29

Fig. 44 shows a structure of the organic optical element of this example. On one glass substrate 1, ITO film 13 having a thickness of 20 nm and $SiO_2$ film 3 having a thickness of 10 nm are formed. On $SiO_2$ film 3, three cycles of acceptor molecule film 4 and first photosensitive molecule film 5 are laminated and three cycles of acceptor molecule film 4 and second photosensitive molecule film 9 are further laminated to form a super-lattice structure. On this super-lattice structure, insulating molecule film 14 which also served as a liquid crystal orientation film is provided. On the other glass substrate 1, ITO film 13 having a thickness of 20 nm and insulating molecule film 14 which also served as a liquid crystal orientation film are provided. Both glass substrates 1, 1 are sealed to each other by sealant 15 via spacer (not indicated) with insulating/liquid crystal orienting films 14, 14 being inside, and liquid crystal molecule layer 16 is formed between the substrates.

The element is produced almost similarly as in Example 25. The super-lattice structure consisting of acceptor molecule film 4, first and second photosensitive molecule films 5 and 9, and insulating/liquid crystal orientation film 14 is formed by LB method. In this example, first photosensitive molecule film 5 uses two-layered film of copper phthalocyanine derivative (2) and second photosensitive molecule film uses two-layered film of the mixed monomolecular film (molar ratio of 1 : 1) of Ni phthalocyanine (5) and stearic acid.

In the element of this example, copper phthalocyanine derivative (2) exhibits absorbance at 633 nm, while it exhibits almost no absorbance at 830 nm which is the wavelength of near infrared semiconductor laser. On the other hand, Ni phthalocyanine derivative (5) exhibits almost no absorbance at 633 nm, while it exhibits marked absorbance at 830 nm. Cholanyl-TCNQ (1) does not exhibit absorbance at any of the both wavelength.

In this element, two exciting lights of 633 nm and 830 nm are applicable. It is indicated that the transparency of the element can be controlled by using the two exciting lights at the same time.

Example 30

The element is evaluated for the characteristics of an optical element similarly as in Example 25 except for using halogen lump whose wavelengths of 500 nm or less are cut instead of He-Ne laser beam. The result indicated that it is an element with plasticity whose threshold for optical switching can be controlled.

Example 31

The element is produced and evaluated for the operation similarly as in Example 25 except for using acceptor molecule (8) instead of acceptor molecule (1).

At the bias voltage of 8 V, transmitting light intensity is increased rapidly once He-Ne laser intensity has reached to 0.65 $mW/cm^2$. Thus, it is indicated that the threshold of the exciting beam intensity can be varied by changing acceptor molecules.

Example 32

The element is produced and evaluated for the operation similarly as in Example 25 except for using acceptor molecule of (6) instead of acceptor molecule (1).

At the bias voltage of 8 V, transmitting laser intensity is increased rapidly once He-Ne laser intensity has reached to 0.7 $mW/cm^2$.

Example 33

The element is produced and evaluated for the operation similarly as in Example 26 except for using acceptor molecule (8) instead of acceptor molecule (1).

When He-Ne laser beam (wavelength 633 nm) is irradiated at the bias voltage of 8 V, the intensity of transmitting light of 550 nm is increased rapidly once the laser intensity has reached to 0.64 $mW/cm^2$, and the light transmittance is observed for about 5 minutes even after the termination of the irradiation. When the laser beam is irradiated again 7 minutes after the termination of the irradiation, it is indicated that the threshold is decreased to 0.5 $mW/cm^2$. Thus, it is indicated that the threshold of the exciting beam intensity and storage time can be varied by changing acceptor molecules.

Example 34

The element is produced and evaluated for the operation similarly as in Example 26 except for using donor molecule (7) instead of donor molecule (3).

When He-Ne laser beam (633 nm) is irradiated at the bias voltage of 8 V, the intensity of transmitting light of 550 nm is increased rapidly once the laser intensity has reached to 0-68 $mW/cm^2$, and the light transmittance is observed for about 5 minutes even after the termination of the irradiation. When the laser beam is irradiated again six minutes after the termination of the irradiation, the threshold is reduced to 0.55 $mW/cm^2$.

Example 35

The element is produced and evaluated for the operation similarly as in Example 26 except for using donor molecule (7) instead of donor molecule (3) and acceptor molecule (8) instead of acceptor molecule (1).

When He-Ne laser beam (633 nm) is irradiated at the bias voltage of 8 V, the intensity of transmitting light of 550 nm is increased rapidly once the laser intensity has reached to 0.8 $mW/cm^2$, and light transmittance is observed for about 3 minutes even after the termination of the irradiation. When the laser beam is irradiated again 5 minutes after the termination of the irradiation, the threshold is reduced to 0.75 $mW/cm^2$.

Example 36

The element is produced and evaluated for the operation similarly as in Example 25 except for using TN liquid crystal instead of ferroelectric liquid crystal.

When exciting beam is irradiated at the bias voltage of 11 V, the liquid crystal layer is switched from transparent to opaque.

Example 37

The element is produced and evaluated for the operation similarly as in Example 36 except for using polyisobutylmethacrylate (4) of the MW of 200,000 laminated at 12.5 dyn/cm instead of trimethylsilylcyanoethylcellulose (10) and using a insulating/liquid crystal orientation film laminated by drawing the substrate both up and down.

When exciting beam is irradiated at the bias voltage of 12 V, the liquid crystal layer is switched from transparent to opaque.

Example 38

Fig. 45 shows a structure of the organic optical element of this example. On glass substrate 1, ITO film 13 having a thickness of 20 nm, $SiO_2$ film 3 having a thickness of 40 nm, acceptor molecule film 4, photosensitive molecule film 5, donor molecule film 6, insulating molecule film 7, and Aℓ microelectrodes $8_1$ to $8_n$ are successively formed.

This element is produced as follows. ITO film 13 and $SiO_2$ film 3 on glass substrate 1 are formed by sputtering method. Super-lattice structure consisting of acceptor molecule film 4, photosensitive molecule film 5, donor molecule film 6 and insulating molecule film 7 is formed by LB method similarly as in Example 1. In this example, cholanyl-TCNQ of formula (1) as an acceptor molecule, copper phthalocyanine derivative of formula (2) as a photosensitive molecule, p-phenylenediamine derivative of formula (3) as a donor molecule and polyisobutylmethacrylate of the MW of 200,000 which has the repeating unit of formula (4) as an insulating molecule are employed.

Aℓ microelectrodes $8_1$ to $8_n$ are formed by vacuum deposition of Aℓ film to the thickness of 50 nm at $3 \times 10^{-6}$ Torr, after drying the super-lattice structure formed as mentioned above overnight under nitrogen stream, followed by patterning Aℓ film to give the width of 10 μm at the pitch of 4 μm. These Aℓ micro electrodes $8_1$ to $8_n$ are connected in such a manner that three-phase clock pulse voltage as shown in Fig. 46 is supplied.

In the optical element in this example, copper phthalocyanine derivative (2) exhibits marked absorbance at 670 nm of the semiconductor laser, while cholanyl-TCNQ (1), p-phenylenediamine derivative (3) and polyisobutylmethacrylate (4) do not exhibit absorbance.

In this element, when the light of the wavelength of 670 nm is irradiated at the site of Aℓ microelectrode 81, the photosensitive molecules are excited and the electrons and the holes are transferred to LUMO of the acceptor molecule and HOMO of the donor molecule, respectively. The charge-separated state thus established is maintained for a while even in a dark place when a bias voltage with ITO electrode 13 being positive is applied. As shown in Fig. 46, when the bias voltage of 2 V with the side of ITO electrode 13 being positive is applied at the site of Aℓ microelectrode $8_1$, and then the bias voltage of 2 V with the side of ITO electrode 13 being positive is applied at the site of Aℓ microelectrode $8_2$, the electric field causes the separated charges to transfer to the super-thin film below Aℓ microelectrode $8_2$. By applying the similar pulse voltage successively in the direction from Aℓ microelectrode $8_2$ to $8_n$, the separated charges are further transferred. The separated charges can be detected by various method.

More specifically, in the condition where bias voltage of 2 V is applied at the site of Aℓ microelectrode $8_1$ with the side of ITO electrode 13 being positive, semiconductor laser beam (wavelength 670 nm, 5 mW, pulse interval 1 μsec, spot diameter 8 m) is irradiated from the side of glass substrate 1 to effect writing. Then the separated charges are transferred to the site of Aℓ microelectrode $8_n$, where the donor molecule is ionized while absorbing the light of the wavelength of 500 nm, which is used to read the memory. When the laser beam corresponding to the signal of 100110110 is irradiated at the site of Aℓ microelectrode $8_1$ while synchronizing with the clock signal shown in Fig. 46, the same signal could be detected at the site of Aℓ microelectrode $8_n$.

Example 39

Fig. 47 and 48 show a structure of the organic optical element of this example. On glass substrate 1, ITO film 13 having a thickness of 20 nm, $SiO_2$ film 3 having a thickness of 40 nm, acceptor molecule film 4, photosensitive molecule film 5, insulating molecule film 7, and Aℓ microelectrodes $8_1$ to $8_n$ are successively formed. A pair of Aℓ electrodes 18 is provided on the perpendicular sides of acceptor molecule film 4 and photosensitive molecule film 5 at the location corresponding to Aℓ microelectrode $8_n$. Aℓ microelectrodes $8_1$ to $8_n$ are connected in such a manner that three-phase clock pulse is supplied similarly as in Example 38.

This element is made similarly as in Example 38 except for forming a pair of Aℓ electrodes 18 on the sides of acceptor molecule film 4 and photosensitive molecule film 5 and forming no donor molecule film.

In the condition where bias voltage is applied at the site of Aℓ microelectrode $8_1$ with the side of ITO electrode 13 being positive, semiconductor laser beam is irradiated from the side of glass substrate 1 to effect writing. Then the separated charges are transferred to the site of Aℓ microelectrode $8_n$, where the conductivity inside the film is measured by Aℓ electrodes 18 to read the memory.

Unlike the element of Example 38, time for recombination of charges of the element of this example is quite short, since it had no donor molecule film. Accordingly, when used for the long period memory, the element should be refreshed by irradiating the light intermittently at the site of Aℓ microelectrode $8_1$.

Example 40

Fig. 49 shows a structure of the organic optical element of this example. On n-type silicon substrate 31, $SiO_2$ film 3 having a thickness of 20 nm is formed. On a part of the region of the surface of $SiO_2$ film, acceptor molecule film 4, photosensitive molecule film 5, insulating molecule film 7 and semi-transparent Au microelectrodes $11_1$ to $11_n$ are formed successively. On the surface of n-silicon 31 at the location corresponding to the both side of the Au microelectrode $11_n$, $p^+$ source and drain regions 32 and 33 are provided. This structure serves as a field effect transistor (FET) having Au microelectrode $11_n$ as a gate electrode. $SiO_2$ film 3 has contact holes above source and drain regions 32 and 33 where none of acceptor molecule film 4, photosensitive molecule film 5 or insulating molecule film 7 is provided. Source and drain regions 32 and 33 are connected via the contact holes to source and drain electrodes (not indicated), respectively.
Au microelectrodes $11_1$ to $11_n$ are connected similarly as in Example 38 in such a manner that three-phase clock pulse voltage is supplied.

This organic optical element is made similarly as in Example 39 except for using Au microelectrodes $11_1$ to $11_n$ and forming source and drain regions using n-silicon substrate 31.

In the condition where a bias voltage is applied at the site of Au microelectrode $11_1$ with the side of silicon substrate 31 being positive, semiconductor laser beam is irradiated from the side of the Au electrode to effect writing. Then the separated charges are transferred to the site of Au microelectrode $11_n$, where it is measured whether the drain current is generated or not, whereby reading the memory.

Example 41

Fig. 50 shows a structure of the organic optical element of this example. On glass substrate 1, ITO film 13 having a thickness of 20 nm and $SiO_2$ film 3 having a thickness of 10 nm are formed. Above this, 100 cycles of the laminated film consisting of acceptor molecule film 4, photosensitive molecule film 19 made from the mixture of organic molecule O having secondary nonlinear optical effect and photosensitive molecule S and donor molecule film 6 are provided to form a super-lattice structure. Further above this, insulating molecule film 7 and Aℓ electrode 8 are successively formed.

This element is produced as follows. ITO film 13 and $SiO_2$ film 3 on glass substrate 1 are formed by sputtering method. Acceptor molecule film 4, photosensitive molecule film 19, donor molecule film 6 and insulating molecule film 7 is formed by LB method.

As an acceptor molecule, cholanyl-TCNQ of formula (1) is dissolved in toluene to obtain LB film developing solution of 0.5 mg/ml. The molecules are developed over the water surface, and then condensed at the surface pressure of 12 dyn/cm to obtain a solid condensed film. The substrate is drawn from the gas phase down to the water and then drawn from the water up to the gas phase through the solid condensed film of cholanyl-TCNQ (1) at the rate of 2 mm/min to obtain acceptor molecule film 4 consisting of two-layered film of cholanyl-TCNQ (1).

Then equal molar amounts of nitroaniline derivative of formula (11) shown below as a molecule having the secondary non-linear optical effect and cyanine dye derivative of formula (12) shown below as a photosensitive molecule are dissolved in toluene to prepare LB film developing solution of 0.2 mg/ml. The molecules form a solid condensed film at 20 dyn/cm. The substrate is brought slowly into contact with the water surface while being kept horizontally. After the surface pressure has became 0, the substrate is drawn up slowly. This procedure is repeated 5 times to form photosensitive molecule film 19 consisting of five-layered film on acceptor molecule film 4.

Subsequently, as a donor molecule, p-phenylenediamine derivative of formula (3) is dissolved in toluene to obtain LB film developing solution of 0.5 mg/ml. The molecules are developed over the surface of the water and condensed at the surface pressure of 25 dyn/cm to form a solid condensed film. The substrate is drawn down and up to form donor molecule film 6 consisting of two-layered film of p-phenylenediamine derivative (3) over photosensitive molecule film 19.

A hundred cycles of the above procedure is repeated to form the super-lattice structure.

In addition, as an insulating molecule, polyisobutylmethacrylate having a molecular weight of 200,000 with the repeating unit of formula (4) is dissolved in chloroform to obtain LB film developing solution of 0.2 mg/ml. The molecules are developed over the surface of the water and condensed at the surface pressure of 13 dyn/cm to form a solid condensed film. Similarly as mentioned above, insulating molecule film 7 consisting of 50-layered film of polyisobutylmethacrylate 4 is formed on donor molecule film 6.

Aℓ electrode 8 is formed after drying the super-lattice structure film followed by vacuum deposition.

In the optical element in this example, exciting light is irradiated from the side of glass substrate 1. The irradiation causes the photosensitive molecule to be excited, and the electrons and the holes are transferred

to LUMO of the acceptor molecule and HOMO of the donor molecule, respectively. As a result, internal electric field is generated due to the charge separation. The separated charges are increased along with the increase in the irradiation intensity.

Laser beam to be controlled is emitted from one side of the super-lattice structure at a low angle into the film, and then reflected repetitively inside the film until it is taken from the other side. Reference laser beam passes through other path. Then interference light of the laser beam taken with the reference laser beam is detected. The intensity of the interference light is minimum (off) when the phase of one beam is different by half of the wavelength from that of the other, while the intensity is maximum when the phases are the same (on). As mentioned above, when internal electric field is present due to the irradiation, the refractive index of the organic molecules having secondary non-linear optical effect changes due to Pockels effect. As a result, the optical path length of the laser beam passing through the film is changed, whereby changing the phase of the light on the side of the detection. Therefore, switching by means of the intensity of the interference light of the laser beam passing through the film with the reference laser beam is possible. Although this switching can be conducted with a strong exciting light without no electric field being applied between the electrodes, application of the field between the electrodes is helpful for the switching even when the weak exciting light is irradiated. This means that it is possible to produce an optical transistor using external electric field.

More specifically, exciting light of the wavelength within the range from 500 to 700 nm is taken through a filter from a halogen lamp provided on the side of glass substrate 1 and irradiated by opening/closing the shutter. The photosensitive molecule exhibits marked absorbance at this range of the wavelength, while other molecule exhibit no absorbance. Laser beam from the infrared semiconductor laser provided on one side of the super-lattice structure is divided into two beams. One of them is passed through inside of the film, and the other is passed through other path to determine the intensity of the interference light observed on the other side of the super-lattice structure. The optical path length is so adjusted that the intensity of the interference light is minimum when no exciting light is irradiated.

When the element is irradiated with the exciting light for 0.1 second, the change in refractive index of the film due to the internal electric field causes increased intensity of the interference light, resulting in ON state. Since the internal electric field is maintained in this case for a while even after the exciting light is blocked by a shutter, the ON state is maintained for several minute, thus indicating the memory characteristics.

When the voltage of 20 V is applied with the side of ITO electrode 13 being positive, the element is changed into ON state upon irradiation of the light of the intensity of 20% based on the light mentioned above, and the state is maintained for a period more than 10 minutes. When the voltage of 20 V is applied with the side of ITO electrode 13 being negative, the element is changed into ON state upon irradiation of the light of the intensity three times that of the light mentioned above, and then turned into OFF state in less than 0.1 second.

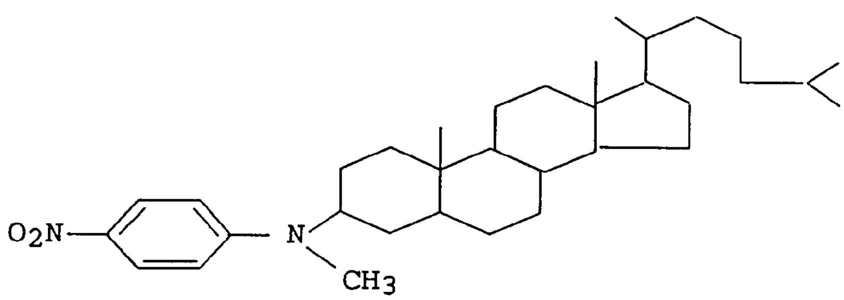

(11)

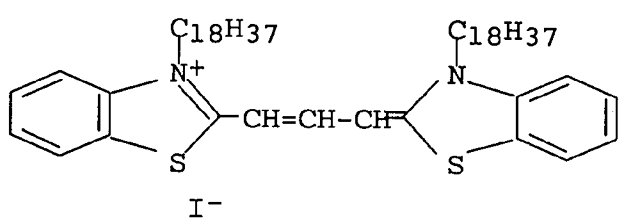

(12)

Example 42

Fig. 51 shows a structure of the organic optical element of this example. On glass substrate 1, ITO film 13 having a thickness of 20 nm and $SiO_2$ film 3 having a thickness of 10 nm are formed. Above this, 100 cycles

of the laminated film consisting of acceptor molecule film 4, and photosensitive molecule film 5 to form a super-lattice structure. Further above this, organic molecule layer 34 (thickness of 1 μm) consisting of organic molecule having secondary non-linear optical effect and Aℓ electrode 8 are successively formed.

This element is produced almost similar as Example 41. A super-lattice structure consisting of acceptor molecule films 4 and photosensitive molecule films 5 is formed by LB method. In this example, as an organic molecule having secondary non-linear optical effect, methylnitroaniline of formula (13) shown below is employed. The organic molecule layer 34 and Aℓ electrode 8 are formed by vacuum deposition on the super-lattice structure.

With the optical element of this example, laser beam from the infrared semiconductor laser is passed through inside of the organic molecule layer 34, and the intensity of the interference light is measured on the other side of the super-lattice structure similar as Example 41.

When the element is irradiated with the exciting light for 0.1 second, the change in refractive index of the film due to the internal electric field causes increased intensity of the interference light, resulting in ON state. However, this optical element turns immediately into OFF when the irradiation of the exciting light is ceased.

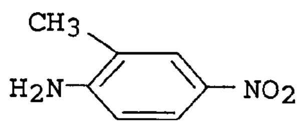

(13)

Example 43

The element is produced and evaluated for the operation similarly as in Example 42 except for using semitransparent Au electrode instead of Aℓ electrode.

In this example, laser beam from the infrared semiconductor laser is irradiated on the side of Au electrode at a low angle. The exciting light is irradiated on the side of glass substrate. The intensity of the interference light by the light reflected at Au electrode and the light passed through and then reflected is determined. The optical path length is so adjusted that the intensity of the interference light is minimum when no exciting light is irradiated.

When the element is irradiated with the exciting light for 0.1 second, the change in refractive index of the film due to the internal electric field causes increased intensity of the interference light, resulting in ON state. However, this optical element turns immediately into OFF when the irradiation of the exciting light is ceased similar as Example 42.

Example 44

The element is produced similarly as in Example 41 except for using photosensitive molecule of formula (14) shown below having secondary non-linear optical effect instead of photosensitive molecule film 19 made from the mixture of organic molecule having secondary non-linear optical effect and photosensitive molecule.

With the optical element of this example, laser beam from the infrared semiconductor laser is passed through inside of the organic thin film, and the intensity of the interference light is measured on the other side of the organic thin film similar as Example 41. When the element is irradiated with the exciting light within a wavelength range from 450 to 600 nm for 0.1 second, the change in refractive index of the film due to the internal electric field causes increased intensity of the interference light, resulting in ON state. Since the internal electric field is maintained in this case for a while even after the exciting light is ceased, the ON state is maintained for several minute, thus indicating the memory characteristics.

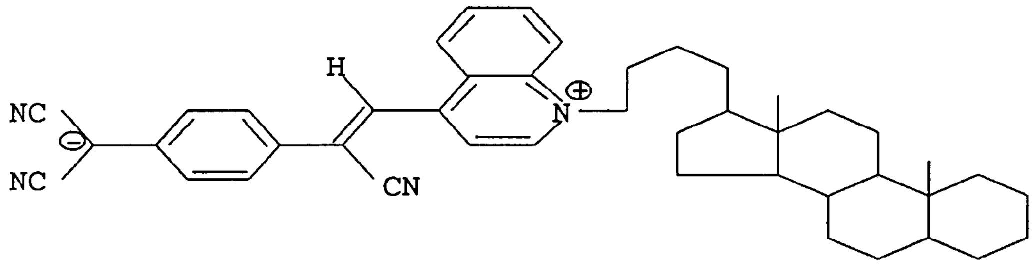

(14)

Example 45

Fig. 52 shows a structure of the organic optical element of this example. On glass substrate 1, ITO film 13 having a thickness of 20 nm and $SiO_2$ film 3 having a thickness of 10 nm are formed. Above this, 200 cycles of the laminated film consisting of acceptor molecule film 20 made from the mixture of organic molecule having secondary non-linear optical effect and acceptor molecule and photosensitive molecule film 5 consisting of photosensitive molecule of formula (2) shown above to form a super-lattice structure. Further above this, insulating molecule film 7 and Aℓ electrode 8 are successively formed.

This element is produced almost similar as Example 41. The acceptor molecule film 20 is formed using equal molar amounts of organic molecule having the secondary non-linear optical effect of formula (15) shown below and acceptor molecule of formula (1) shown above. With the optical element of this example, laser beam from the infrared semiconductor laser is passed through inside of the organic thin film, and the intensity of the interference light is measured on the other side of the super-lattice structure similar as Example 41. When the element is irradiated with the He-Ne laser beam (633 nm) for 0.1 second, the change in refractive index of the film due to the internal electric field causes increased intensity of the interference light, resulting in ON state. However, this optical element turns into OFF within 0.1 second when the irradiation of the He-Ne laser beam is ceased.

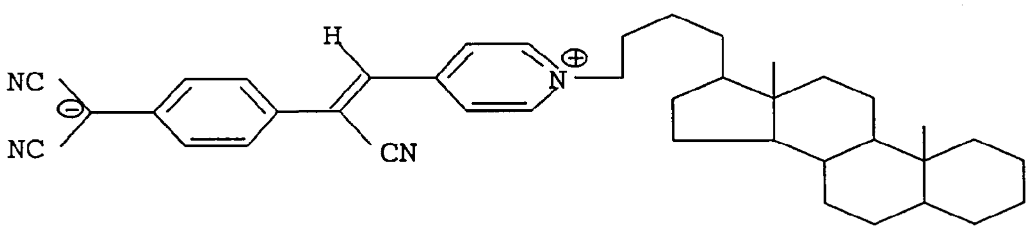

(15)

## Claims

1. An organic optical element comprising:
   an organic thin film comprising a photosensitive molecule film and an organic molecule film having an effect to receive electric charges from the photosensitive molecule film, which is provided adjacent to the photosensitive molecule film; and
   means for controlling the charge-separated state formed by transfer of the charges generated by excitation of the photosensitive molecules to the organic molecules receiving the charges upon irradiation with light within wavelength range which is absorbed by the photosensitive molecules.

2. An element according to claim 1, characterized in that the organic molecule film having the effect to receive the charges is an acceptor molecule film and a donor molecule film each provided on one of the both sides of the photosensitive molecule film.

3. An element according to claim 1, characterized in that the organic molecule film having the effect to receive

the charges is an acceptor molecule film provided on one side of photosensitive molecule film.

4. An element according to claim 1, characterized in that the organic molecule film having the effect to receive the charges is a donor molecule film provided on one side of the photosensitive molecule film.

5. An element according to claim 1, characterized in that the means for controlling the charge-separated state comprises a pair of electrodes provided on the both sides of the organic thin film comprising of the photosensitive molecule film and the organic molecule film having the effect to receive the charges.

6. An element according to claim 5, characterized in that insulating films are provided between the electrodes and the organic thin film comprising the photosensitive molecule film and the organic molecule film having the effect to receive the charges.

7. An element according to claim 6, characterized in that at least one of the pair of electrodes and insulating films on the one side is transparent.

8. An element according to claim 6, characterized in that the organic thin film comprising the photosensitive molecule film and the organic molecule film having the effect to receive the charges, a pair of the insulating films provided on the both sides of the organic thin film and a pair of the electrodes formed outside of the both insulating films, is mounted on a transparent substrate.

9. An element according to claim 1, characterized in that the photosensitive molecule film contains two or more types of the photosensitive molecules.

10. An element according to claim 1, characterized in that two or more organic molecule films having the effect to receive the charges are laminated.

11. An element according to claim 1, characterized in that two or more cycles of organic thin films comprising the photosensitive molecule film and the organic molecule film having the effect to receive the charges are provided, and two or more types of the photosensitive molecules are used.

12. An element according to claim 1, characterized in that two or more cycles of organic thin films comprising the photosensitive molecule film and the organic molecule film having the effect to receive the charges are provided, and two or more types of the organic molecules having the effect to receive the charges are used.

13. An element according to claim 1, characterized in that electrodes detecting the charge-separated state are provided on the two perpendicular sides of the organic thin film comprising the photosensitive molecule film and the organic molecule film having the effect to receive the charges.

14. An element according to claim 1, characterized in that the organic thin film comprising the photosensitive molecule film and the organic molecule film having the effect to receive the charges is provided at the gate region of a field effect transistor.

15. An element according to claim 1, characterized in that one of the pair of the electrodes consists of a group of microelectrodes aligned separately from each other, and the charges are transferred by applying the clock pulse voltage to the microelectrodes.

16. An organic optical element comprising:

an organic thin film comprising a photosensitive molecule film and an organic molecule film having an effect to receive electric charges from the photosensitive molecule film, which is provided adjacent to the photosensitive molecule film;

a liquid crystal layer provided close to the organic thin film; and

means for controlling the charge-separated state formed by transfer of the charges generated by excitation of the photosensitive molecules to the organic molecules receiving the charges upon irradiation with light within wavelength range which is absorbed by the photosensitive molecules,

wherein orientation of the liquid crystal molecules is controlled by an electric field generated by the charge separation.

**17.** An organic optical element comprising:

an organic thin film comprising a photosensitive molecule film and an organic molecule film having an effect to receive electric charges from the photosensitive molecule film, which is provided adjacent to the photosensitive molecule film; and

means for controlling the charge-separated state formed by transfer of the charges generated by excitation of the photosensitive molecules to the organic molecules receiving the charges upon irradiation with light within wavelength range which is absorbed by the photosensitive molecules,

wherein organic molecules having non-linear optical effect are contained in the organic thin film comprising the photosensitive molecule film and the organic molecule film having effect to receive the charges, and optical characteristics of the organic molecules are controlled by an electric field generated by the charge separation.

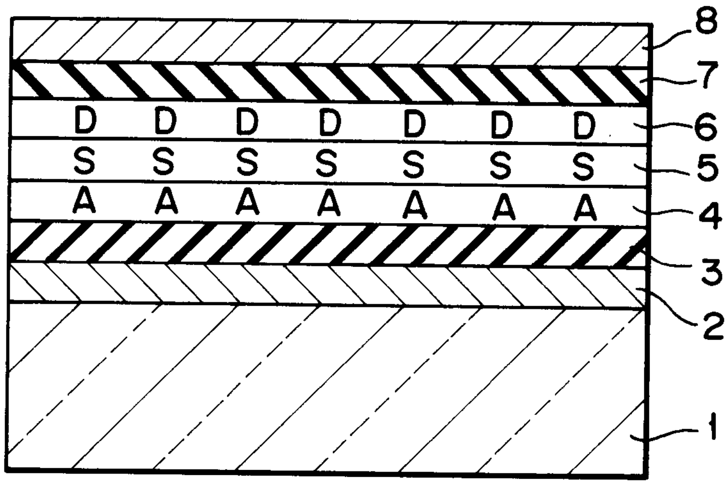
8
7
D D D D D D D
6
S S S S S S S
5
A A A A A A A
4
3
2
1

F I G. 1

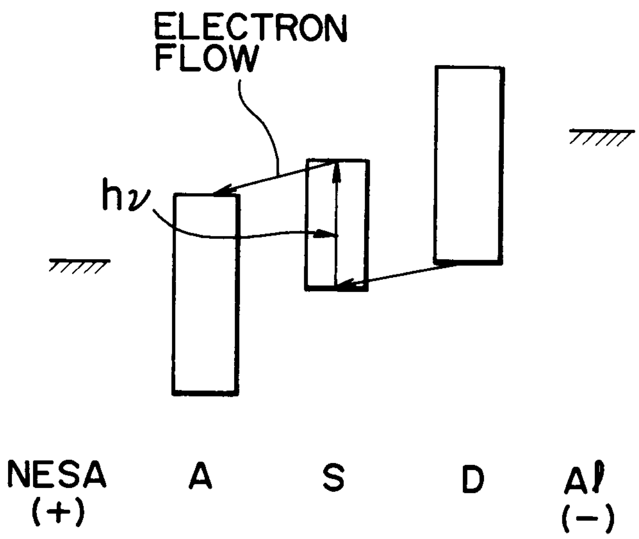
ELECTRON FLOW
hν
NESA (+)
A
S
D
Al (−)

F I G. 2

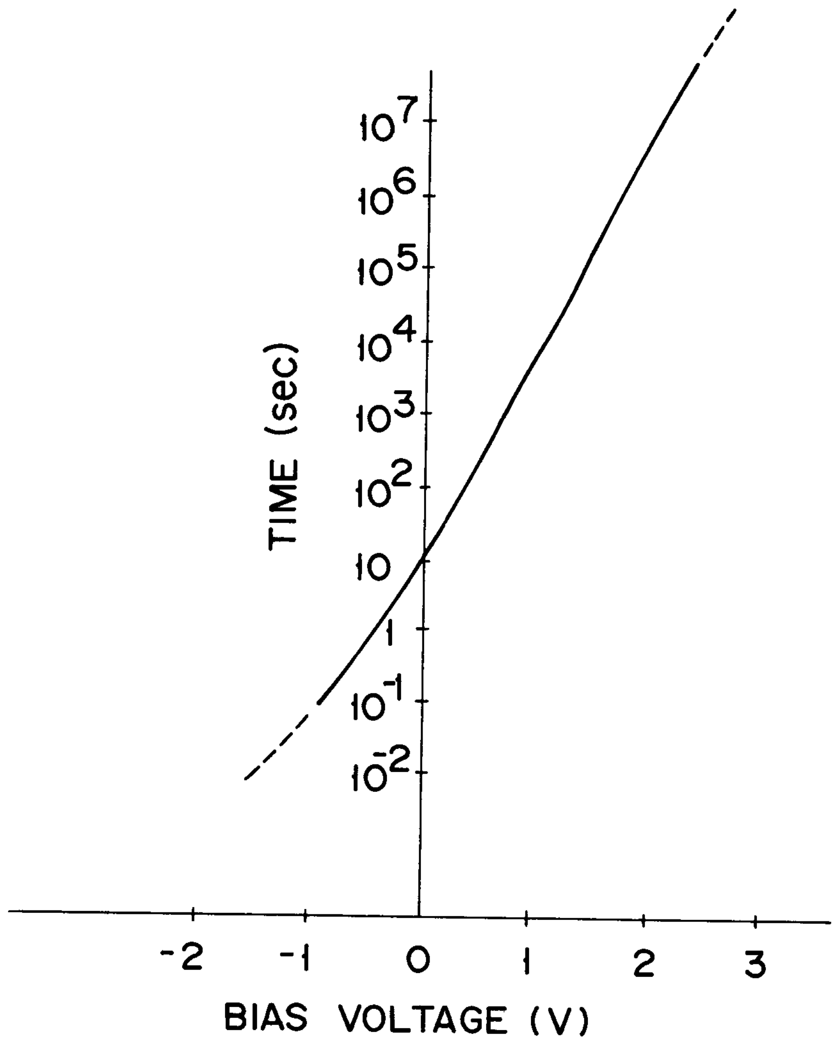

$10^7$
$10^6$
$10^5$
$10^4$
$10^3$
$10^2$
10
1
$10^{-1}$
$10^{-2}$
TIME (sec)
-2
-1
0
1
2
3
BIAS VOLTAGE (V)


FIG. 3

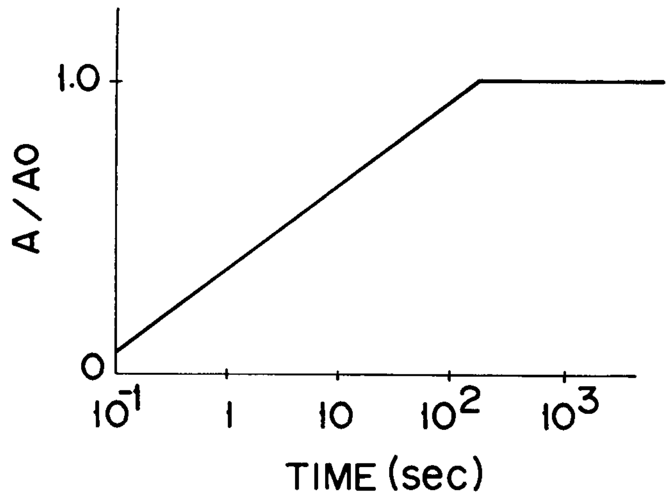
1.0
A / AO
0
$10^{-1}$
1
10
$10^2$
$10^3$
TIME (sec)

FIG. 4

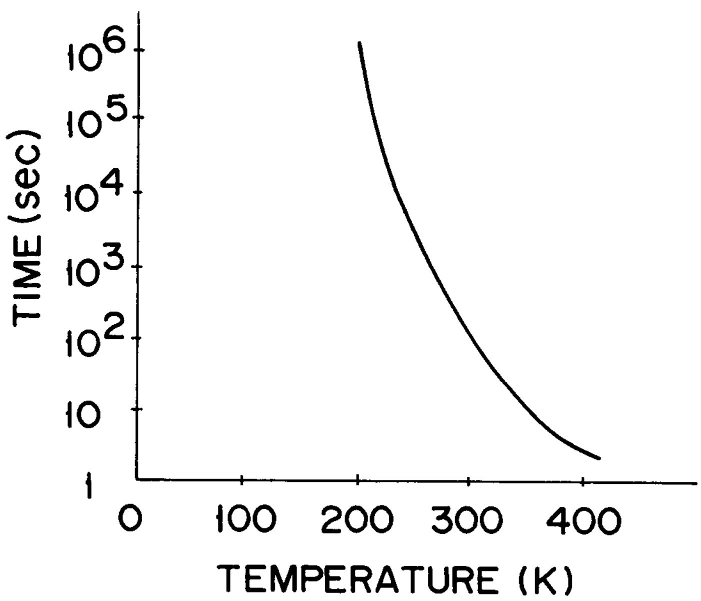
$10^6$
$10^5$
$10^4$
$10^3$
$10^2$
10
1
TIME (sec)
0
100
200
300
400
TEMPERATURE (K)

FIG. 5

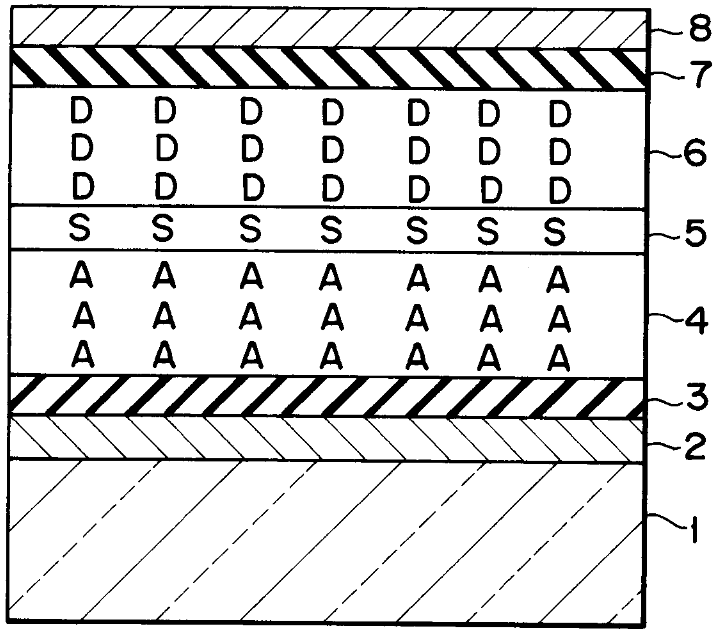
8
7
D D D D D D D
D D D D D D D
D D D D D D D
6
S S S S S S S
5
A A A A A A A
A A A A A A A
A A A A A A A
4
3
2
1

FIG. 6

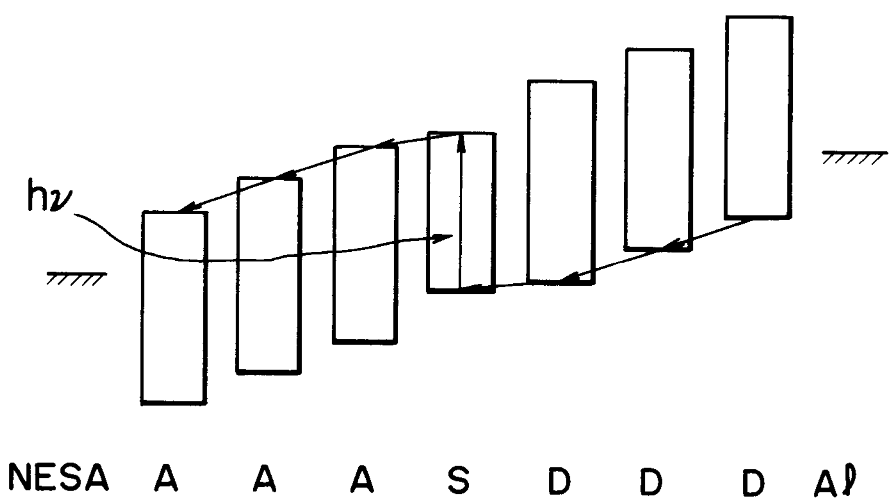
hν
NESA A A A S D D D Al

FIG. 7

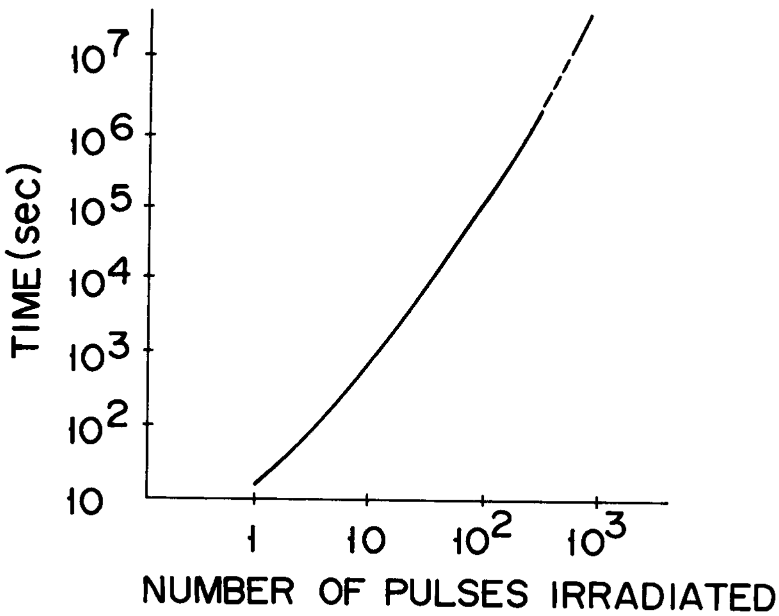
TIME (sec)
10
$10^2$
$10^3$
$10^4$
$10^5$
$10^6$
$10^7$
1
10
$10^2$
$10^3$
NUMBER OF PULSES IRRADIATED

FIG. 8

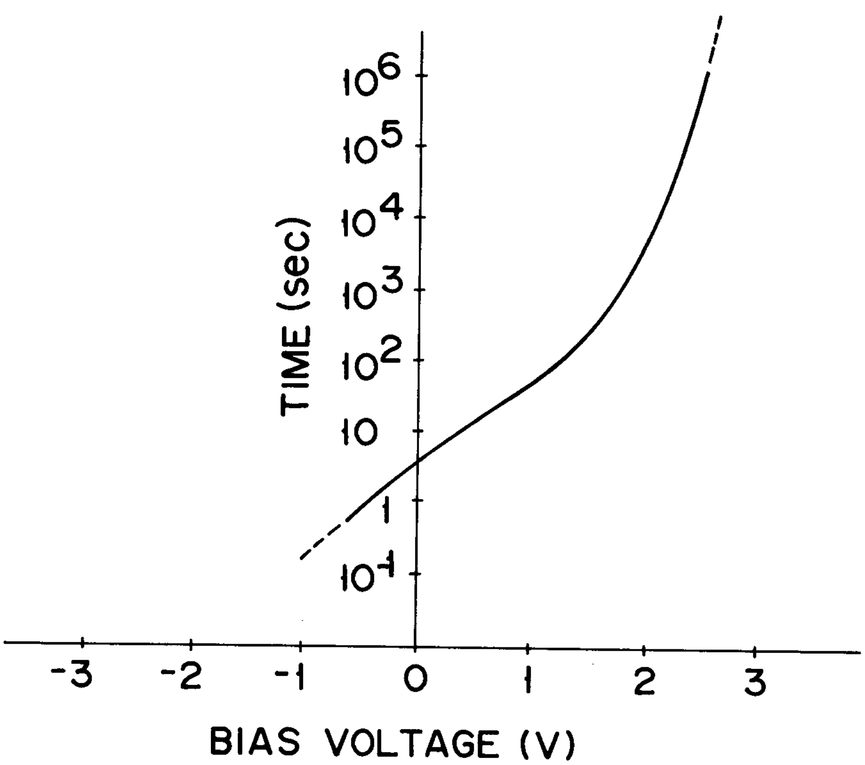
TIME (sec)
$10^{-1}$
1
10
$10^2$
$10^3$
$10^4$
$10^5$
$10^6$
-3
-2
-1
0
1
2
3
BIAS VOLTAGE (V)

FIG. 9

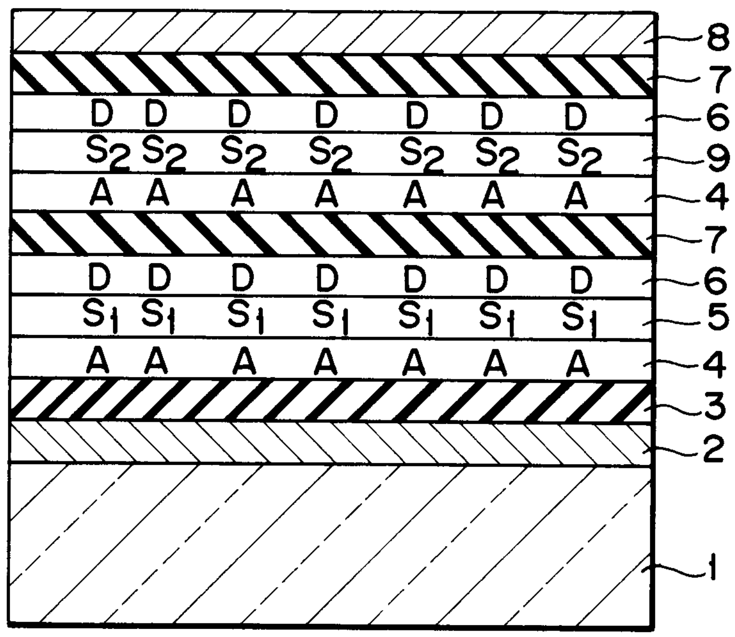
8
7
D D D D D D D
6
S2 S2 S2 S2 S2 S2 S2
9
A A A A A A A
4
7
D D D D D D D
6
S1 S1 S1 S1 S1 S1 S1
5
A A A A A A A
4
3
2
1

F I G. 10

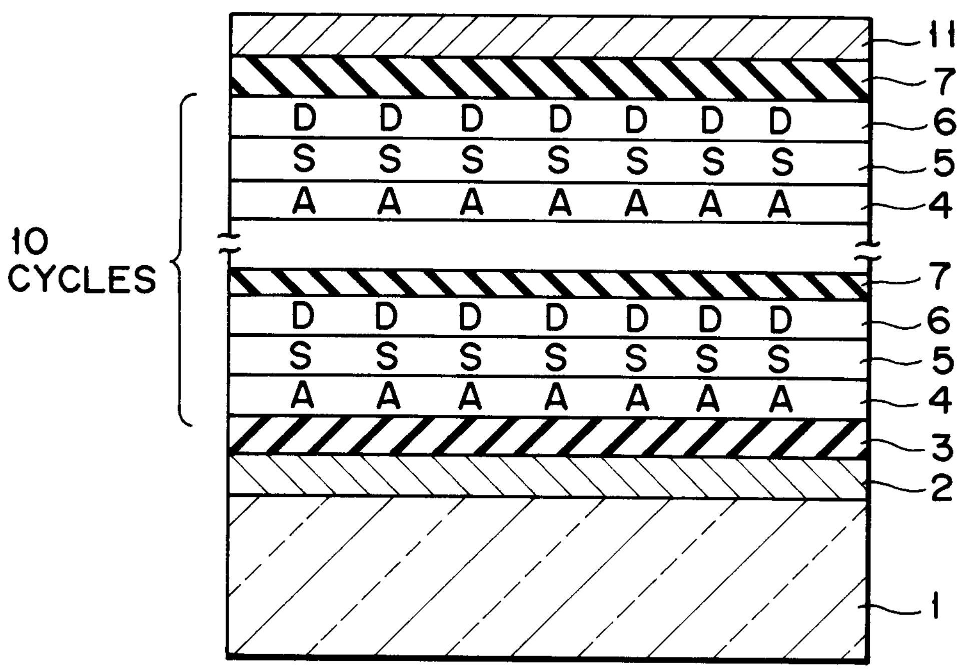
11
7
D D D D D D D
6
S S S S S S S
5
A A A A A A A
4
10 CYCLES
7
D D D D D D D
6
S S S S S S S
5
A A A A A A A
4
3
2
1

F I G. 11

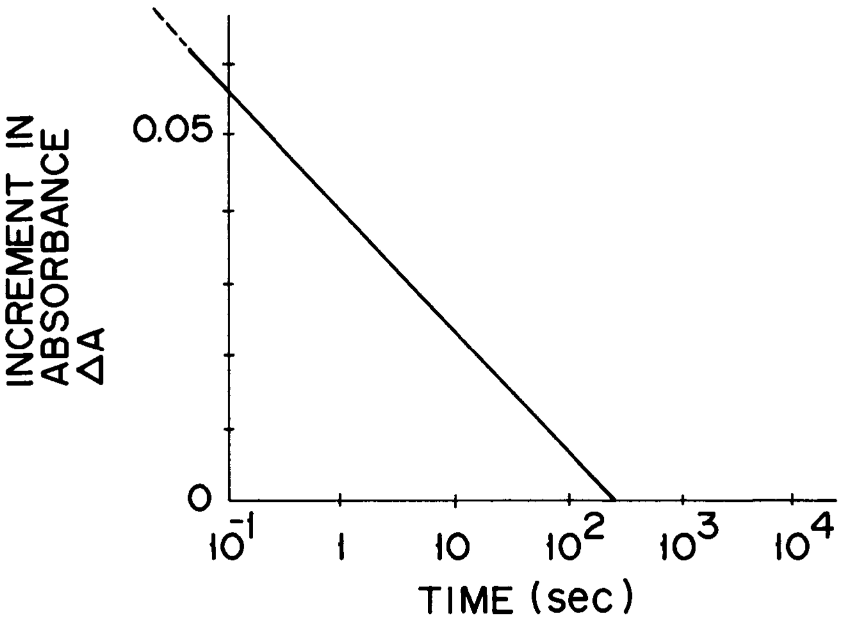
INCREMENT IN ABSORBANCE ΔA
0.05
0
10⁻¹
1
10
10²
10³
10⁴
TIME (sec)

FIG. 12

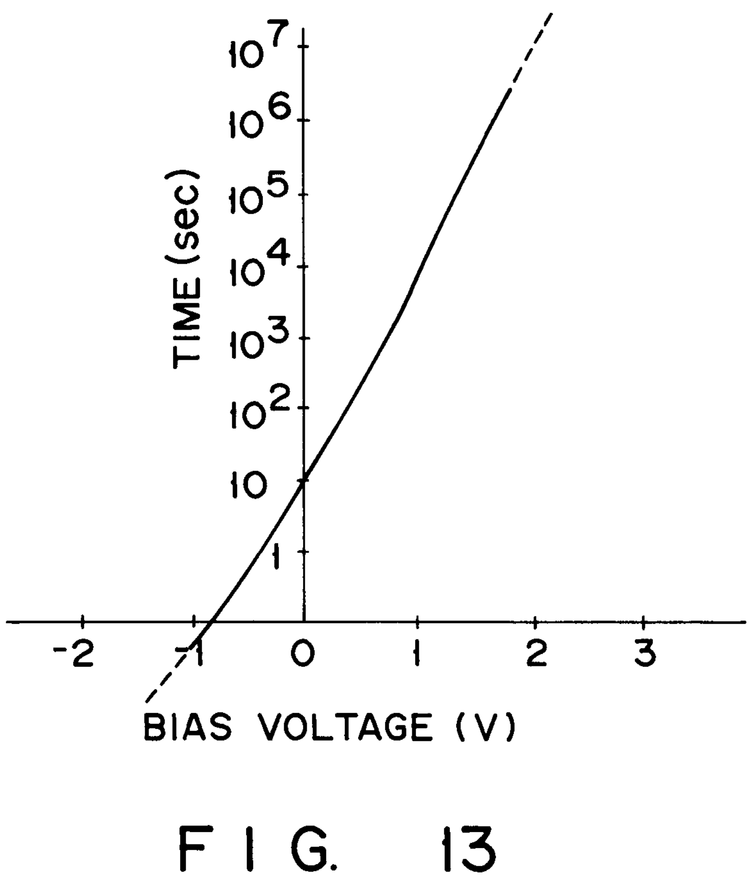
TIME (sec)
10⁷
10⁶
10⁵
10⁴
10³
10²
10
1
-2
-1
0
1
2
3
BIAS VOLTAGE (V)

FIG. 13

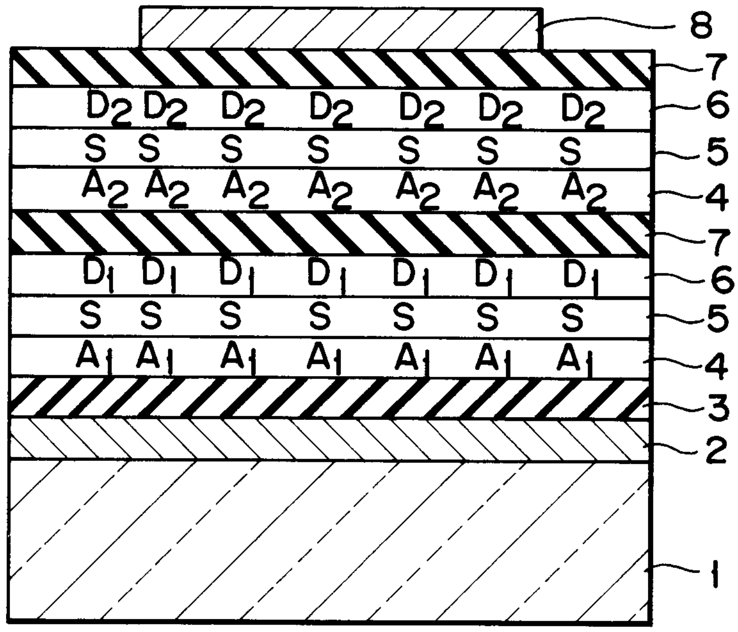
8
7
D2 D2 D2 D2 D2 D2 D2
6
S S S S S S S
5
A2 A2 A2 A2 A2 A2 A2
4
7
D1 D1 D1 D1 D1 D1 D1
6
S S S S S S S
5
A1 A1 A1 A1 A1 A1 A1
4
3
2
1

F I G. 14

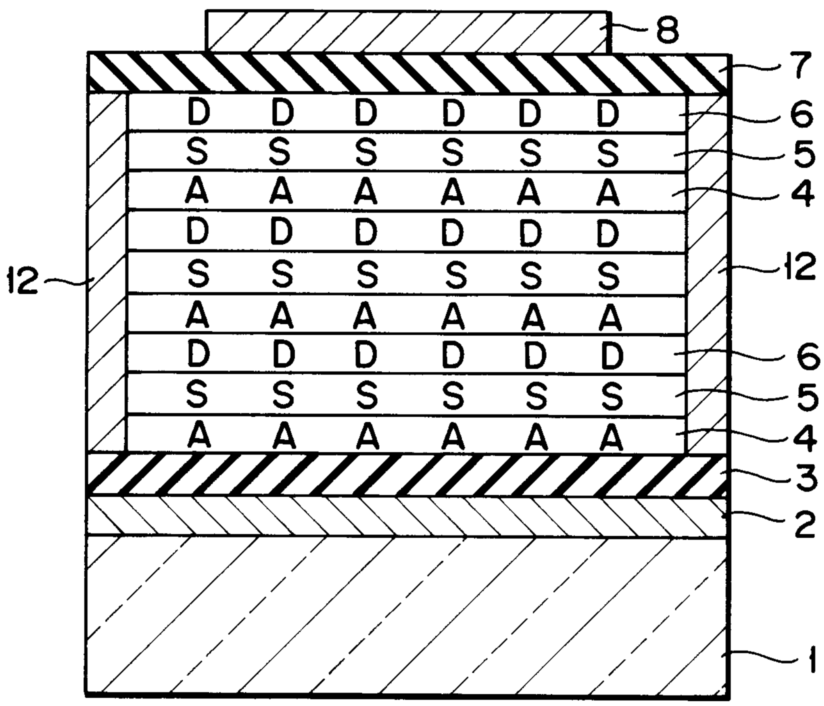
8
7
D D D D D D
6
S S S S S S
5
A A A A A A
4
D D D D D D
12
S S S S S S
12
A A A A A A
D D D D D D
6
S S S S S S
5
A A A A A A
4
3
2
1

F I G. 15

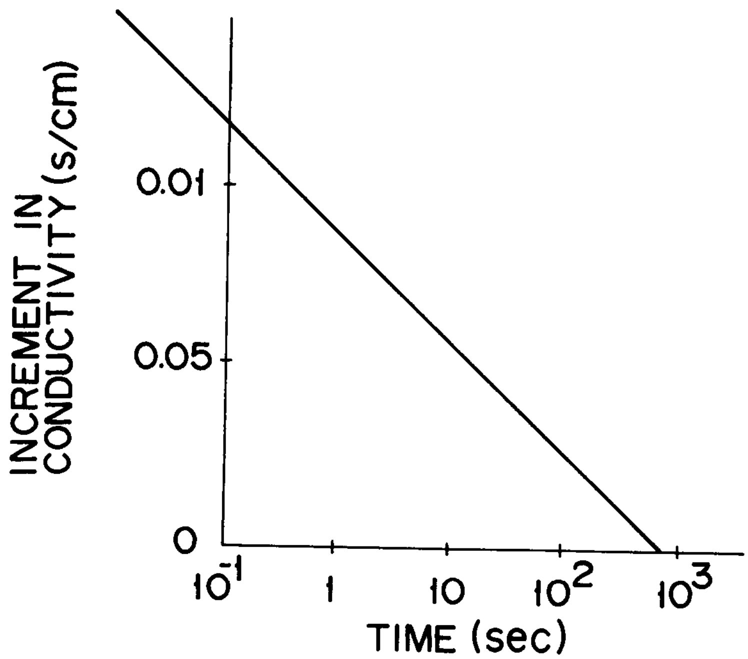
INCREMENT IN CONDUCTIVITY (s/cm)
0.01
0.05
0
$10^{-1}$
1
10
$10^2$
$10^3$
TIME (sec)

F I G. 16

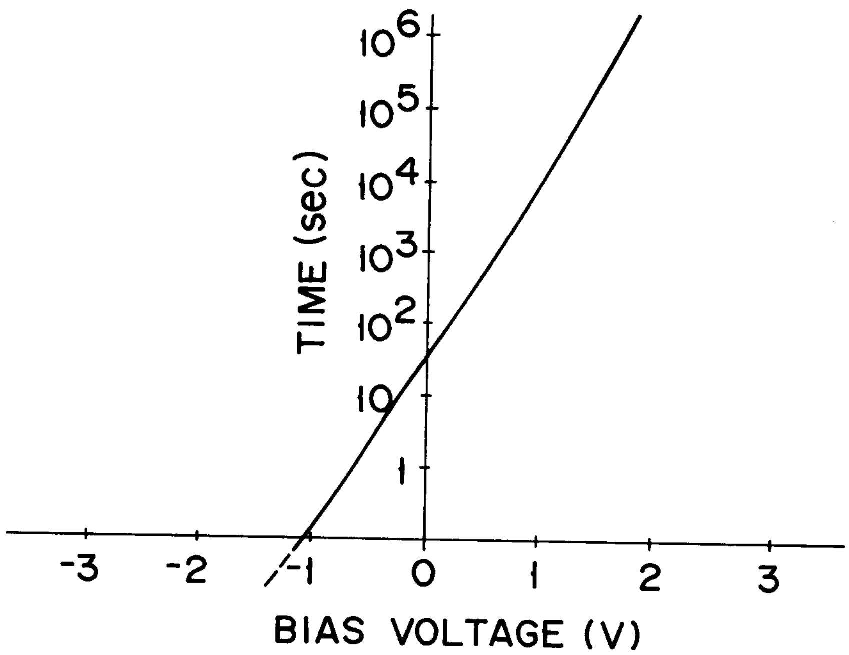
TIME (sec)
$10^6$
$10^5$
$10^4$
$10^3$
$10^2$
10
1
-3
-2
-1
0
1
2
3
BIAS VOLTAGE (V)

F I G. 17

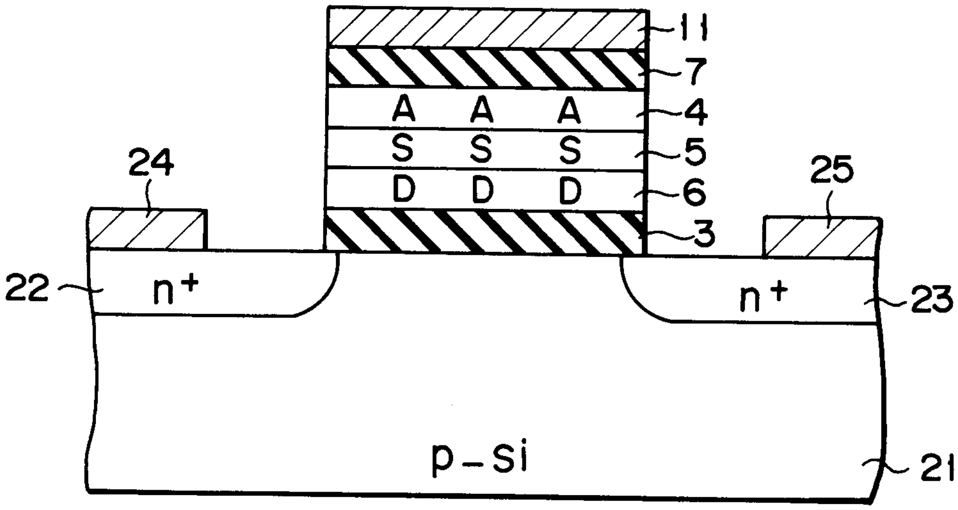
11
7
A A A
4
S S S
5
D D D
6
3
24
25
22
n+
n+
23
p-si
21

FIG. 18

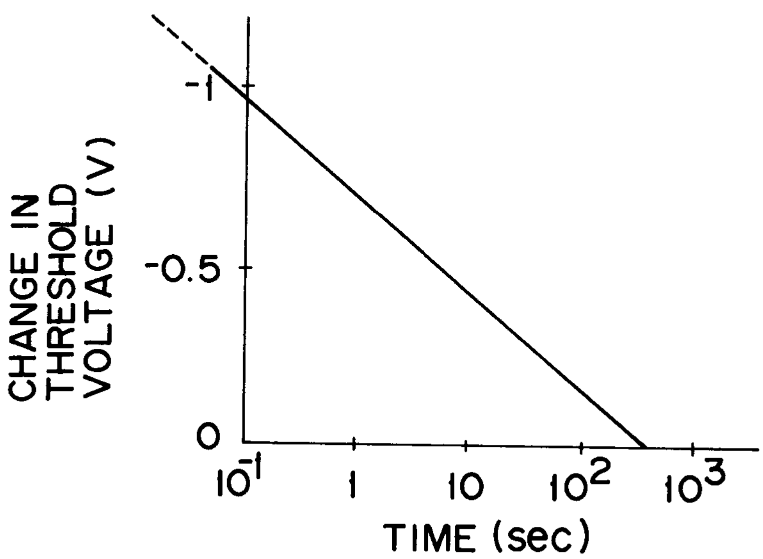
CHANGE IN THRESHOLD VOLTAGE (V)
-1
-0.5
0
$10^{-1}$
1
10
$10^2$
$10^3$
TIME (sec)

FIG. 19

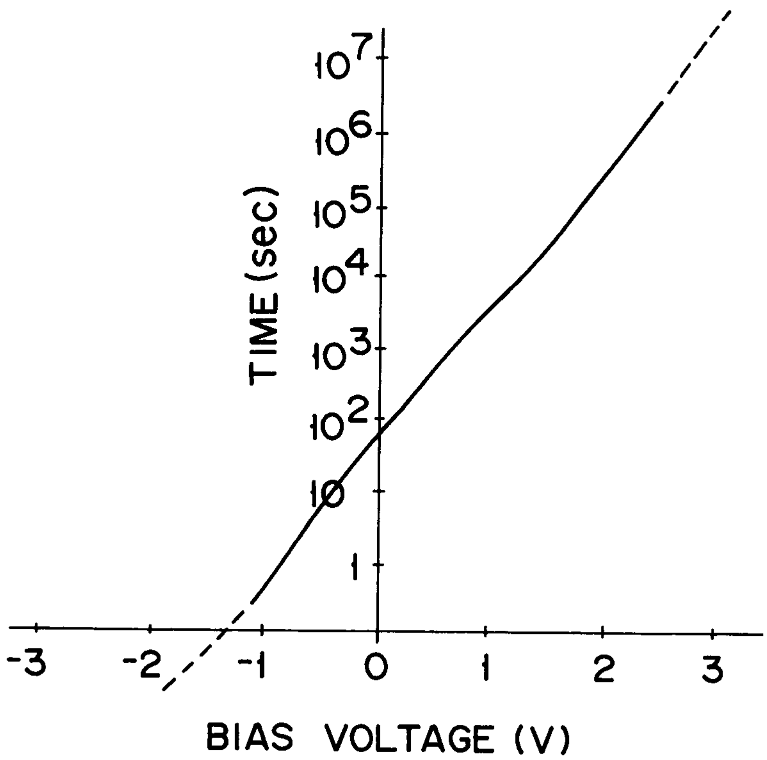


F I G. 20

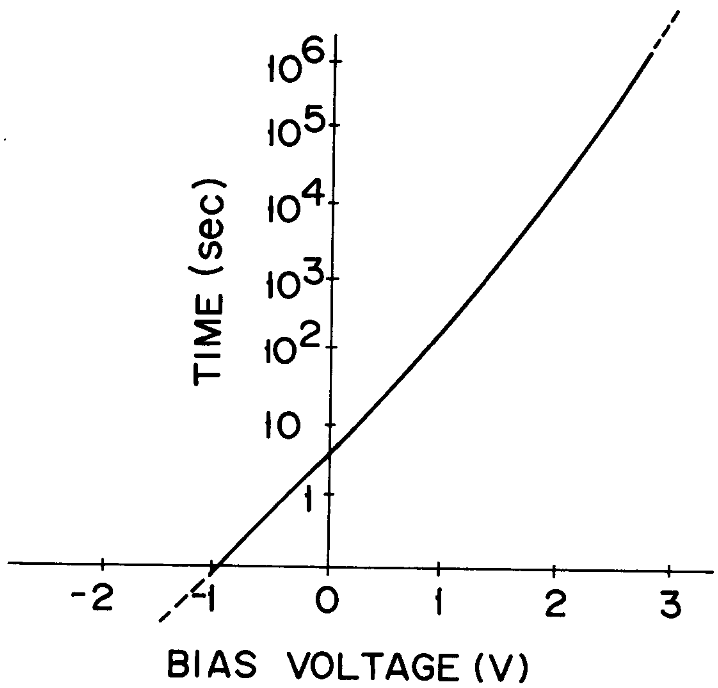
TIME (sec)
10^6
10^5
10^4
10^3
10^2
10
1
-2
-1
0
1
2
3
BIAS VOLTAGE (V)

FIG. 21

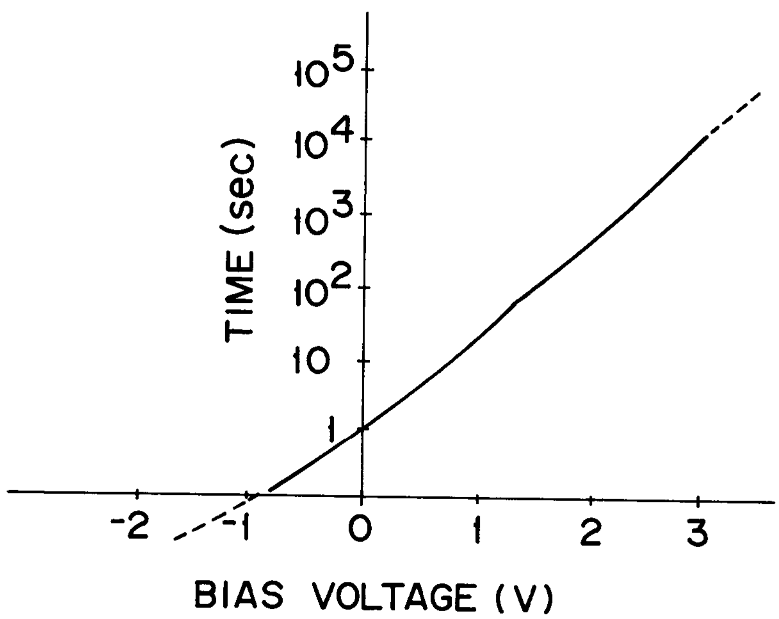
TIME (sec)
10^5
10^4
10^3
10^2
10
1
-2
-1
0
1
2
3
BIAS VOLTAGE (V)

FIG. 22

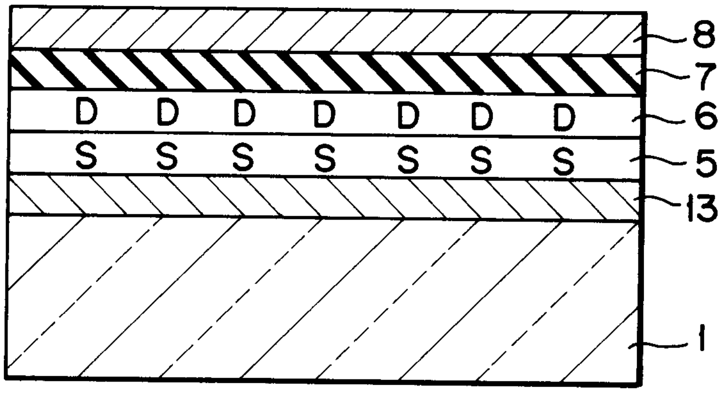


FIG. 23

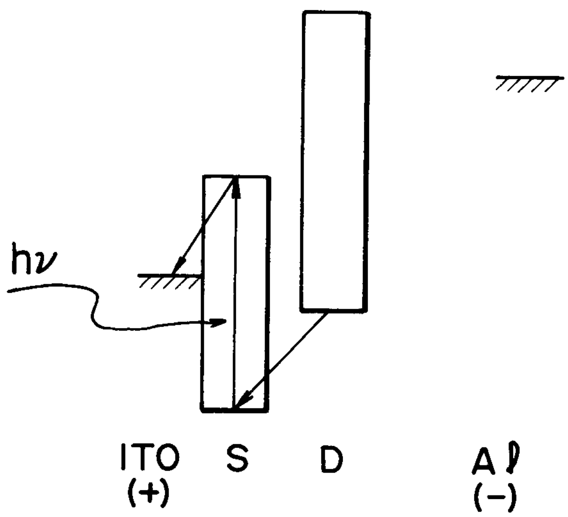


FIG. 24

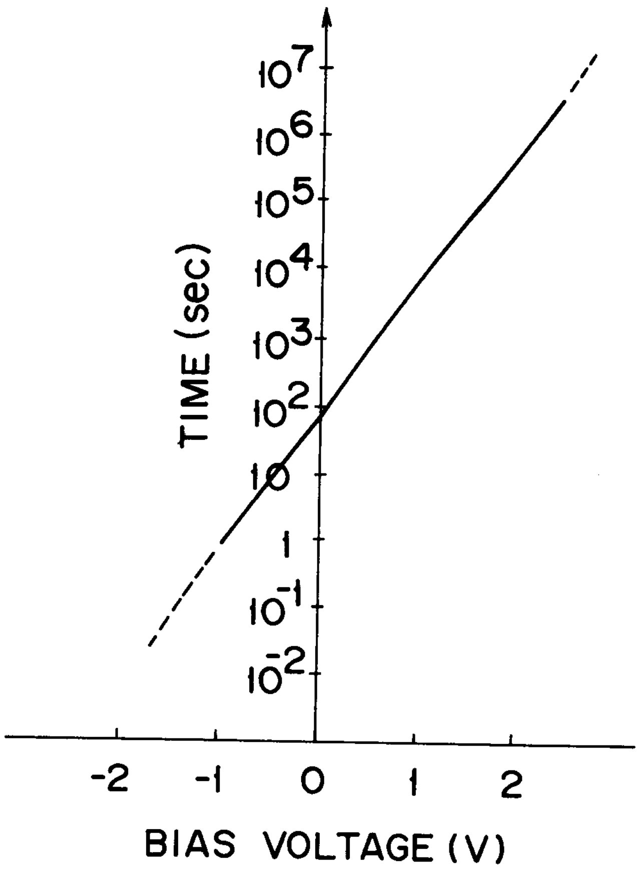
TIME (sec)
10^7
10^6
10^5
10^4
10^3
10^2
10
1
10^-1
10^-2
-2
-1
0
1
2
BIAS VOLTAGE (V)

FIG. 25

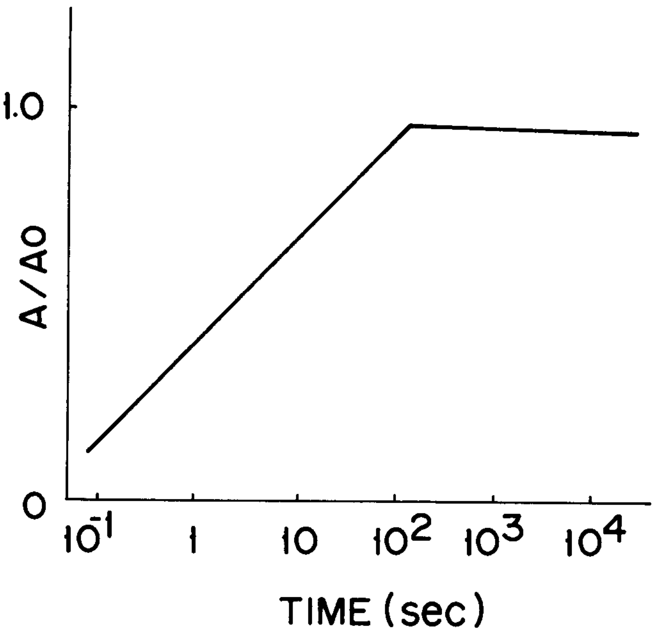
1.0
A/Ao
0
$10^{-1}$
1
10
$10^2$
$10^3$
$10^4$
TIME (sec)

F I G. 26

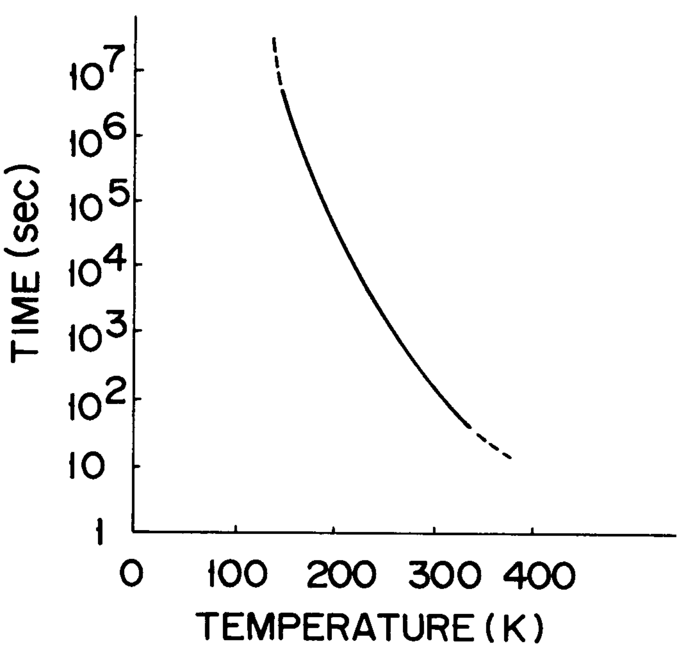
$10^7$
$10^6$
$10^5$
$10^4$
$10^3$
$10^2$
10
1
TIME (sec)
0
100
200
300
400
TEMPERATURE (K)

F I G. 27

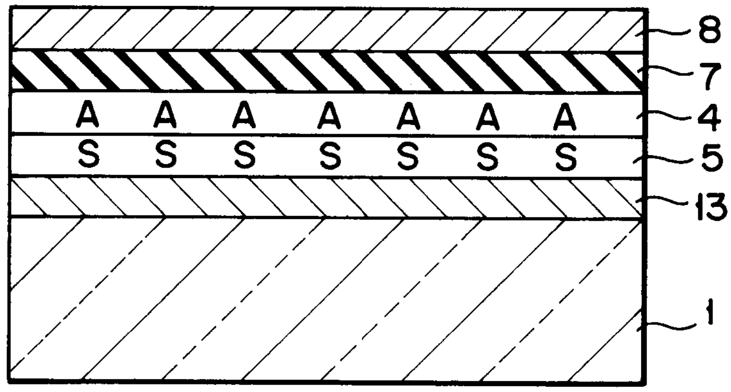


F I G. 28

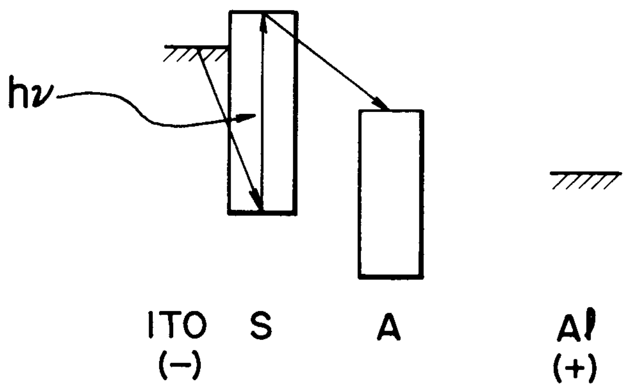


F I G. 29

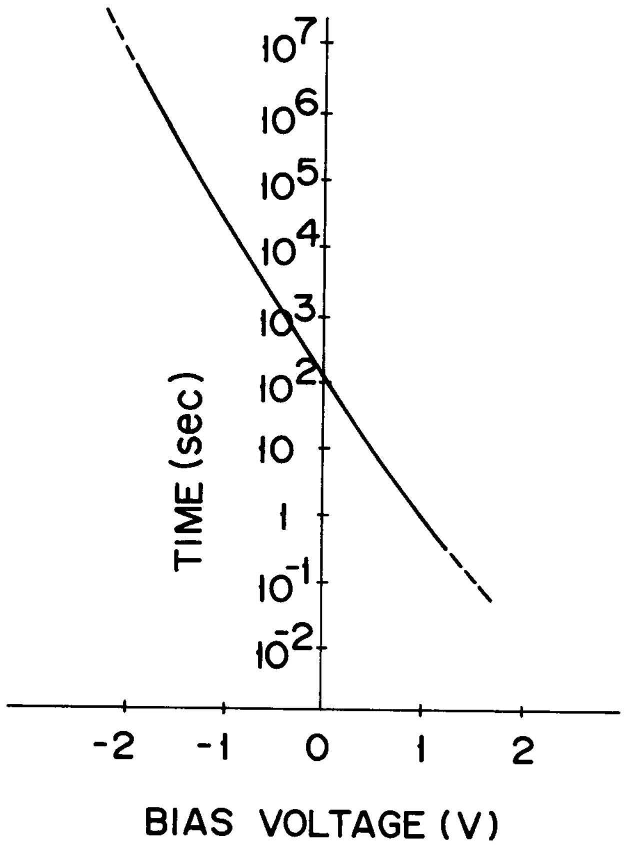
$10^7$
$10^6$
$10^5$
$10^4$
$10^3$
$10^2$
10
1
$10^{-1}$
$10^{-2}$
TIME (sec)
-2
-1
0
1
2
BIAS VOLTAGE (V)

FIG. 30

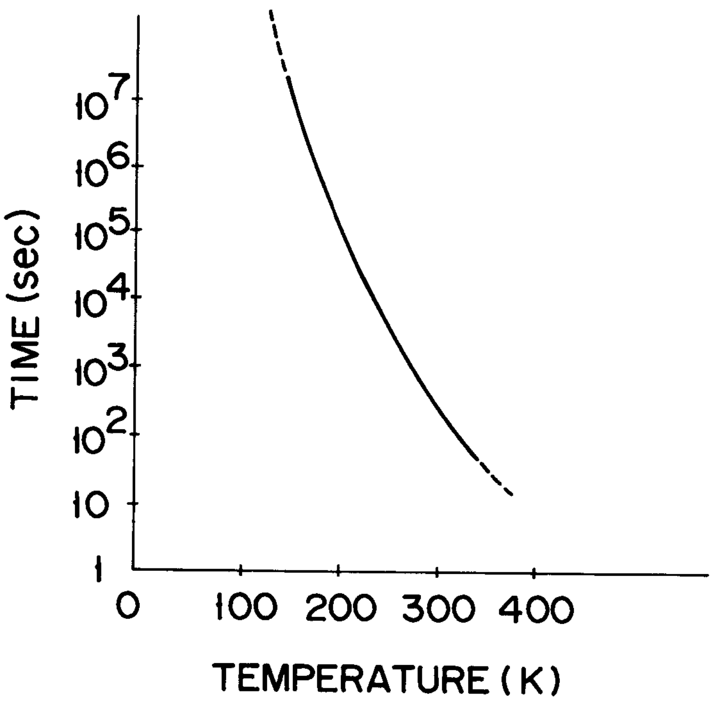
TIME (sec)
10⁷
10⁶
10⁵
10⁴
10³
10²
10
1
0
100
200
300
400
TEMPERATURE (K)

FIG. 31

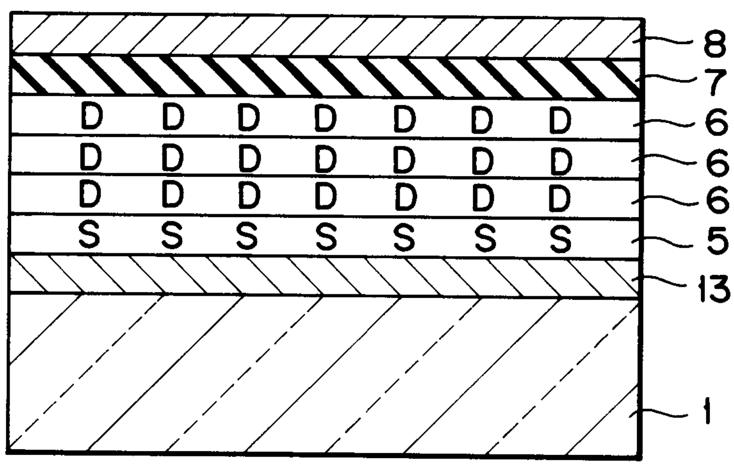
D D D D D D D
D D D D D D D
D D D D D D D
S S S S S S S
8
7
6
6
6
5
13
1

FIG. 32

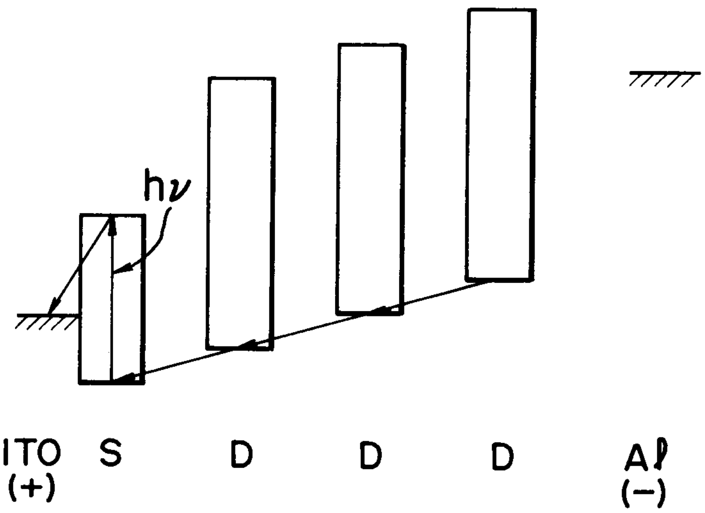
hν
ITO
(+)
S
D
D
D
Aℓ
(−)

FIG. 33

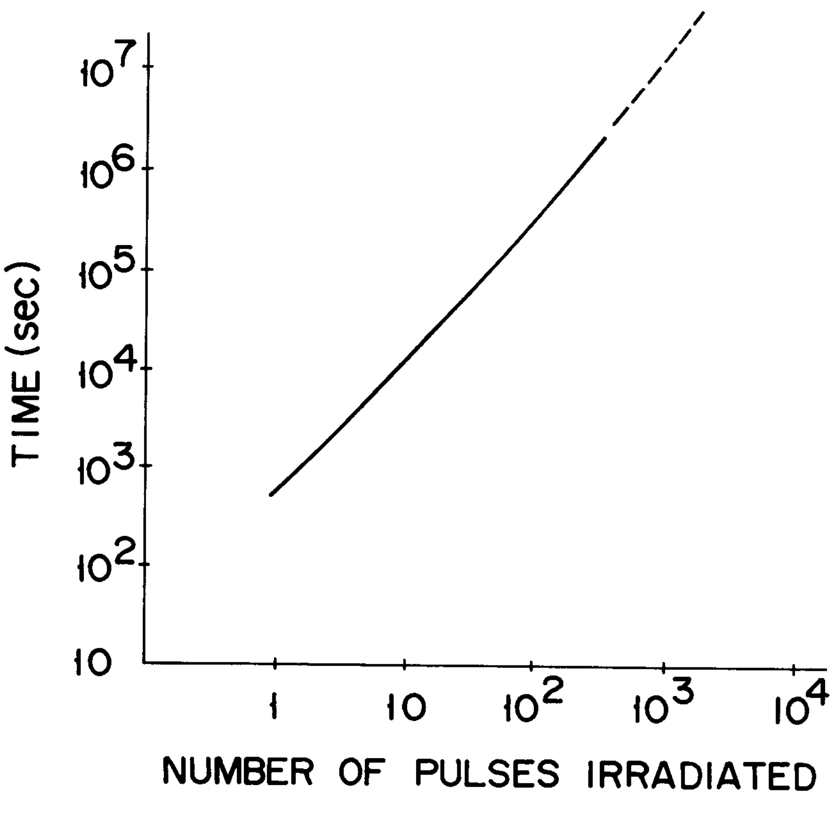
TIME (sec)
10
10^2
10^3
10^4
10^5
10^6
10^7
1
10
10^2
10^3
10^4
NUMBER OF PULSES IRRADIATED

FIG. 34

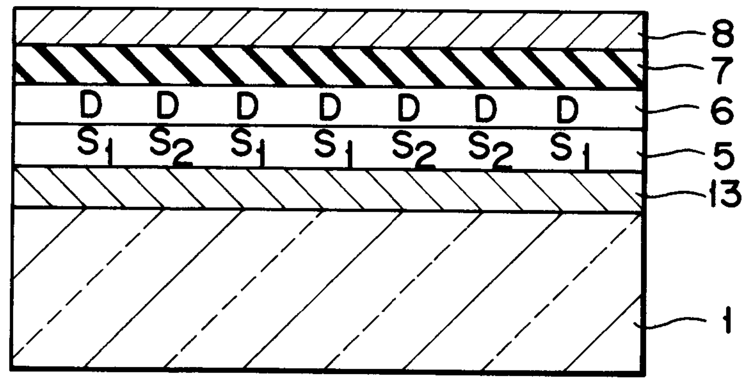
8
7
D D D D D D D
6
S1 S2 S1 S1 S2 S2 S1
5
13
1

F I G. 35

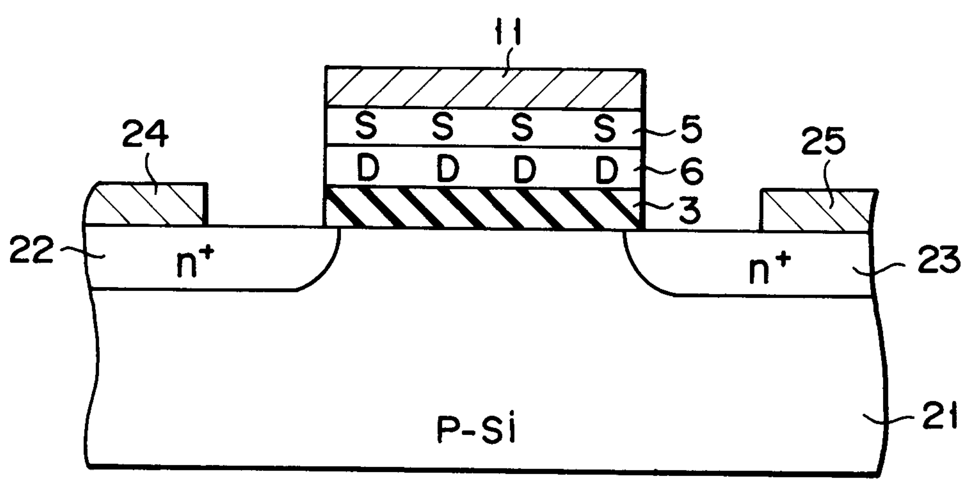
11
S S S S
5
D D D D
6
3
24
25
22
n+
n+
23
P-Si
21

F I G. 36

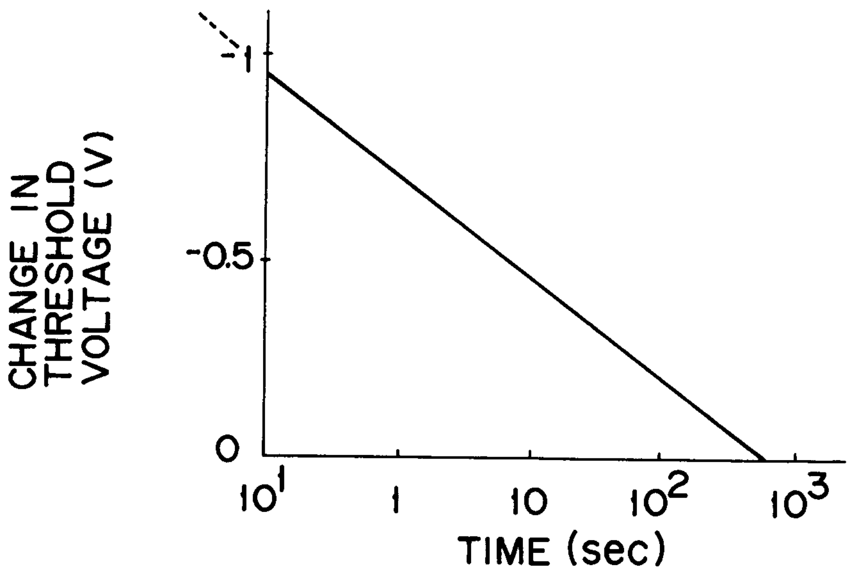
CHANGE IN THRESHOLD VOLTAGE (V)
-1
-0.5
0
$10^1$
1
10
$10^2$
$10^3$
TIME (sec)

FIG. 37

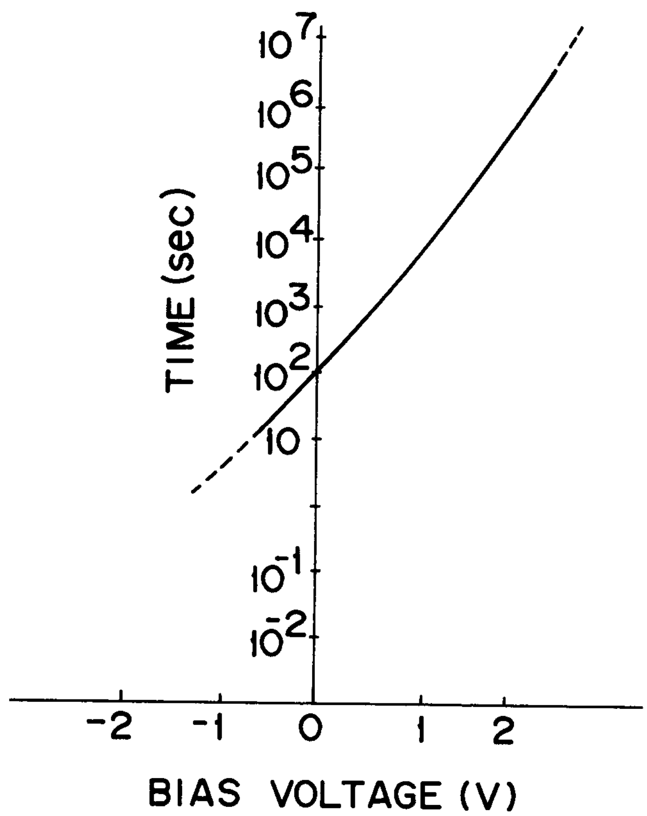
TIME (sec)
$10^7$
$10^6$
$10^5$
$10^4$
$10^3$
$10^2$
10
$10^{-1}$
$10^{-2}$
-2
-1
0
1
2
BIAS VOLTAGE (V)

FIG. 38

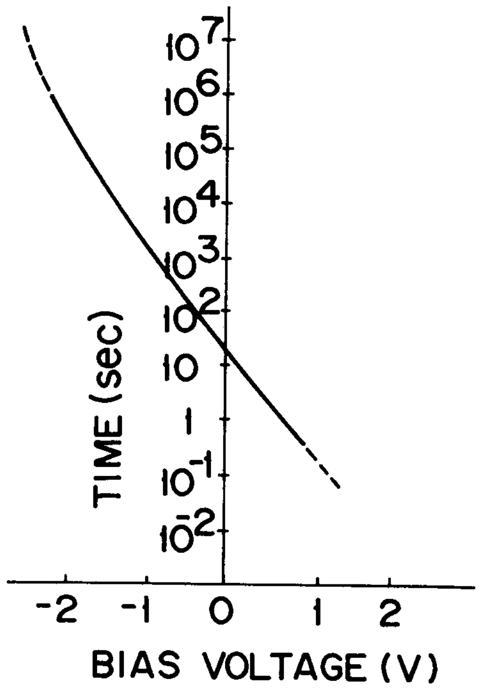
TIME (sec)
10^7
10^6
10^5
10^4
10^3
10^2
10
1
10^-1
10^-2
-2
-1
0
1
2
BIAS VOLTAGE (V)

FIG. 39

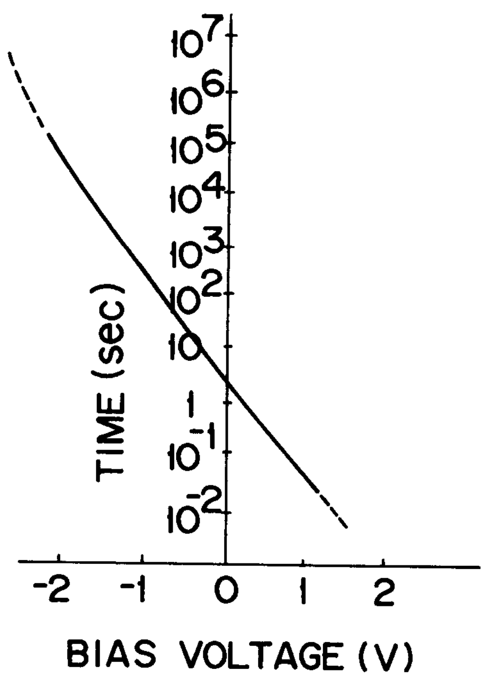
TIME (sec)
10^7
10^6
10^5
10^4
10^3
10^2
10
1
10^-1
10^-2
-2
-1
0
1
2
BIAS VOLTAGE (V)

FIG. 40

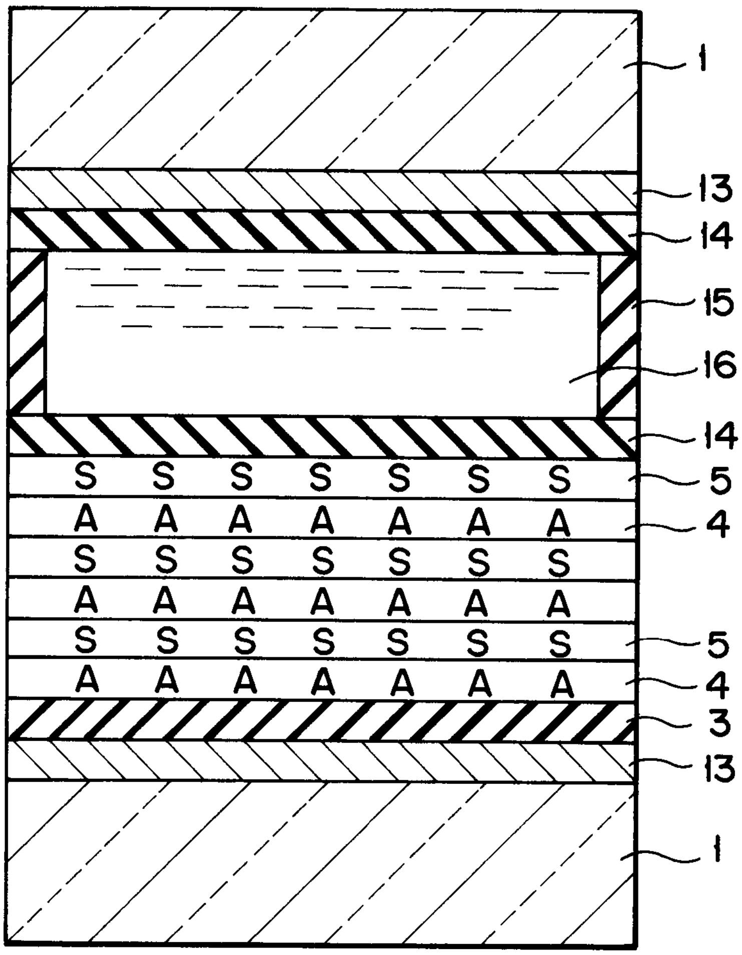
1
13
14
15
16
14
S S S S S S S
5
A A A A A A A
4
S S S S S S S
A A A A A A A
S S S S S S S
5
A A A A A A A
4
3
13
1

F I G. 41

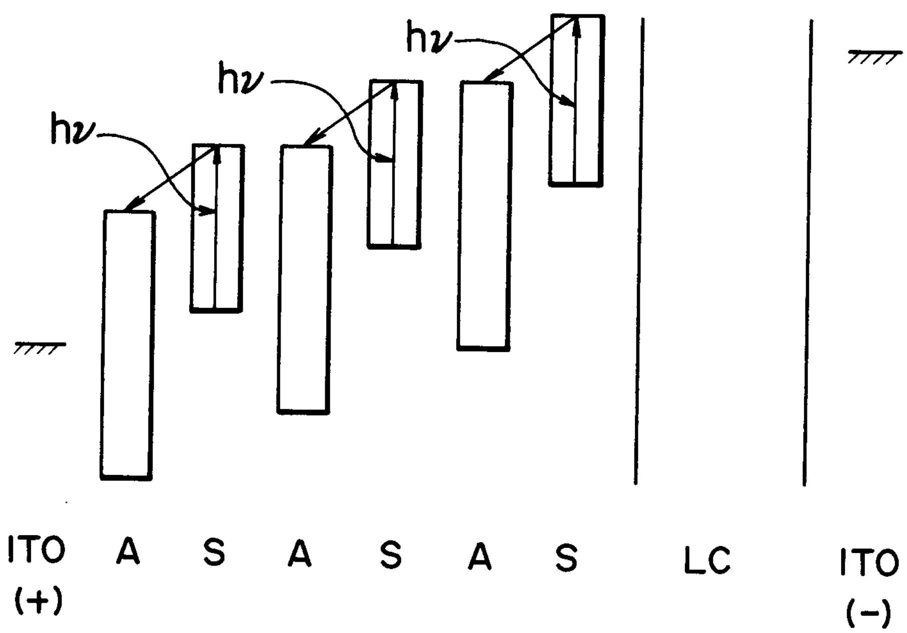


F I G. 42

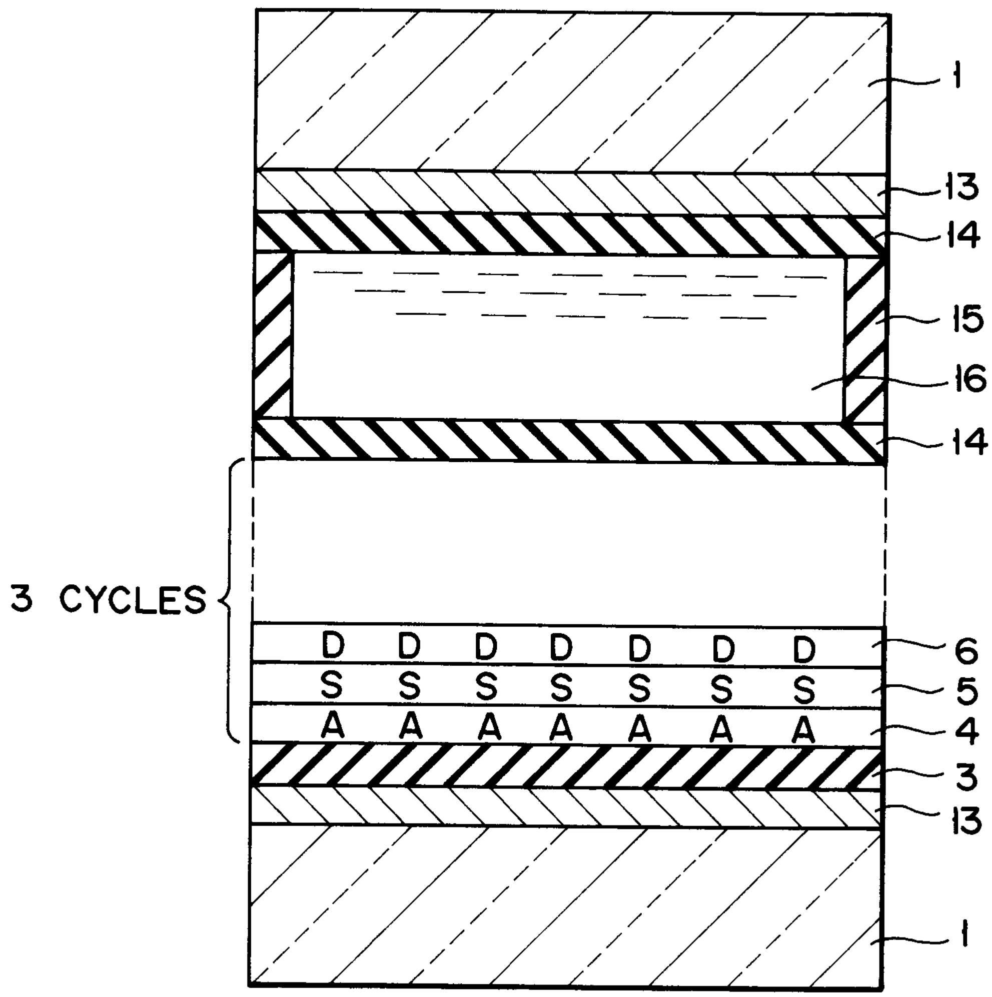


F I G. 43

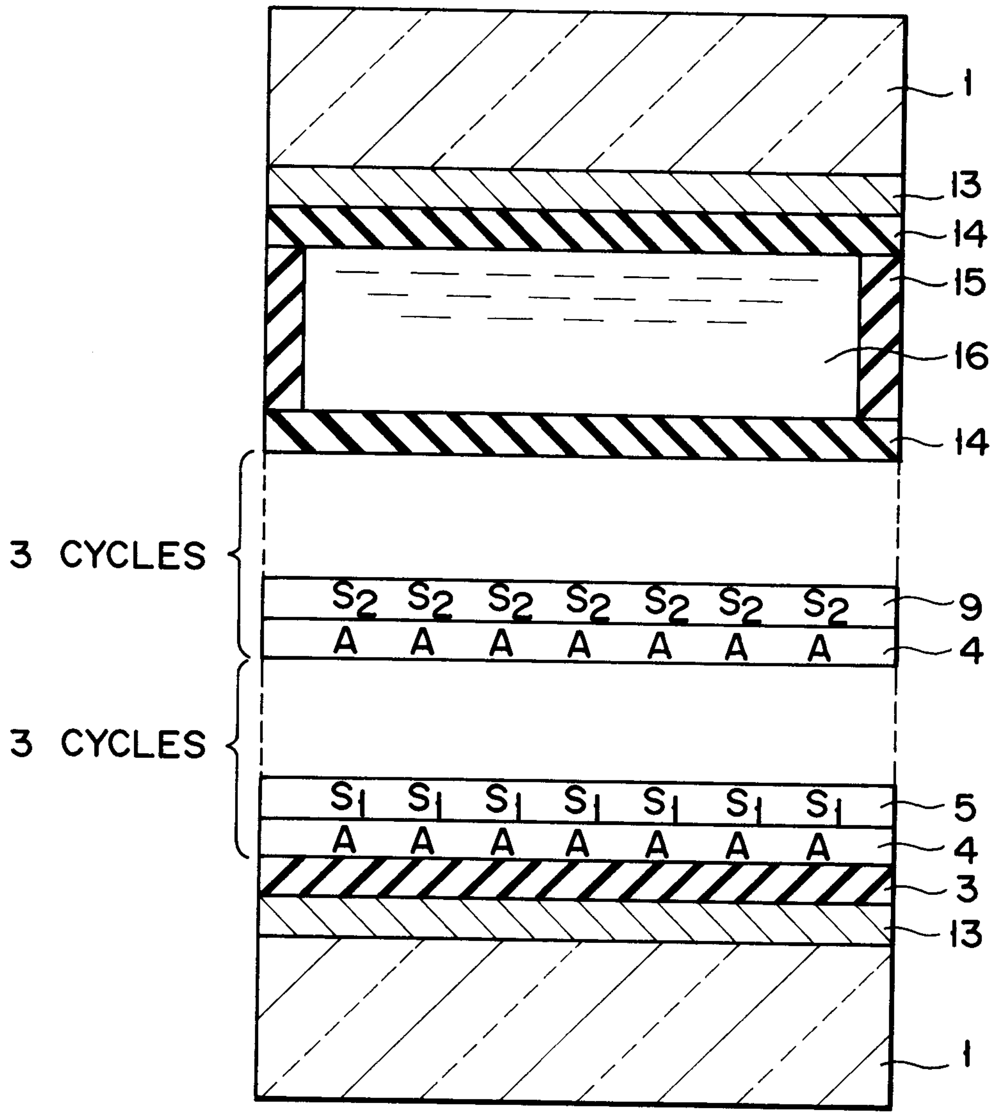
1
13
14
15
16
14
3 CYCLES
S2 S2 S2 S2 S2 S2 S2
A A A A A A A
9
4
3 CYCLES
S1 S1 S1 S1 S1 S1 S1
A A A A A A A
5
4
3
13
1

FIG. 44

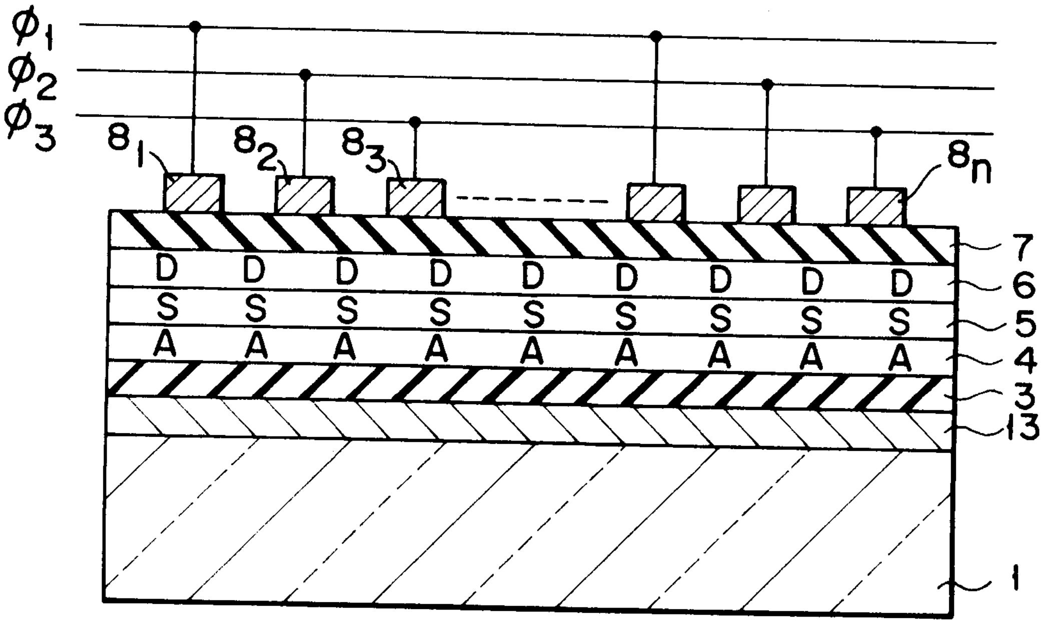

φ1
φ2
φ3
8₁
8₂
8₃
8n
D
S
A
7
6
5
4
3
13
1


FIG. 45

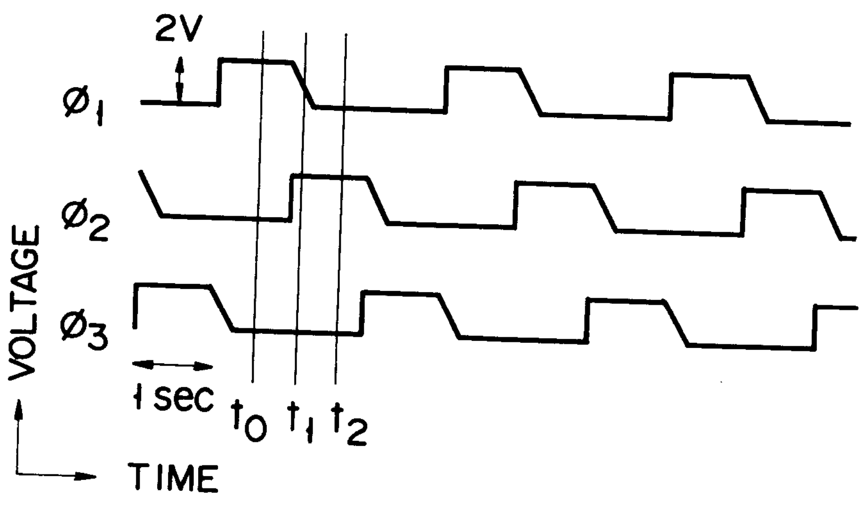

2V
φ1
φ2
φ3
VOLTAGE
1 sec
t0 t1 t2
TIME


FIG. 46

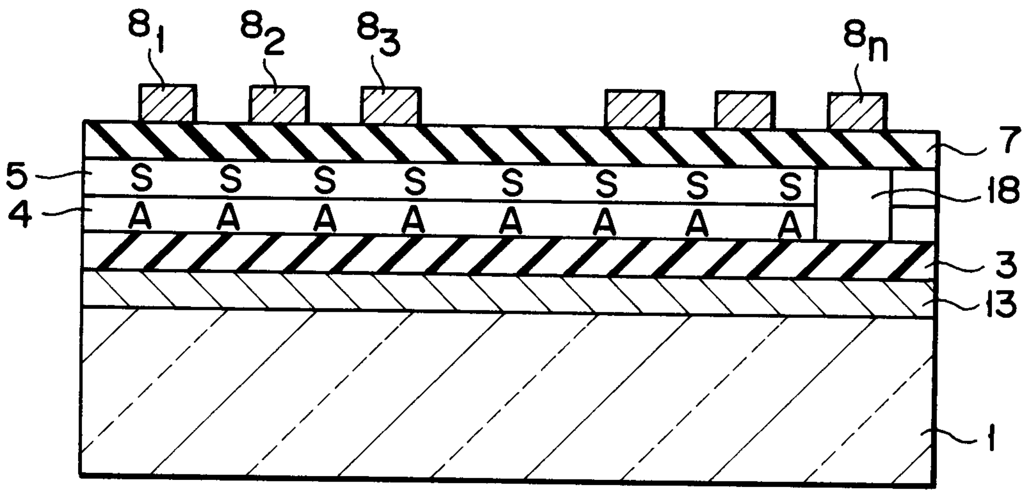
8₁
8₂
8₃
8n
7
5
S S S S S S S S
18
4
A A A A A A A A
3
13
1

F I G. 47

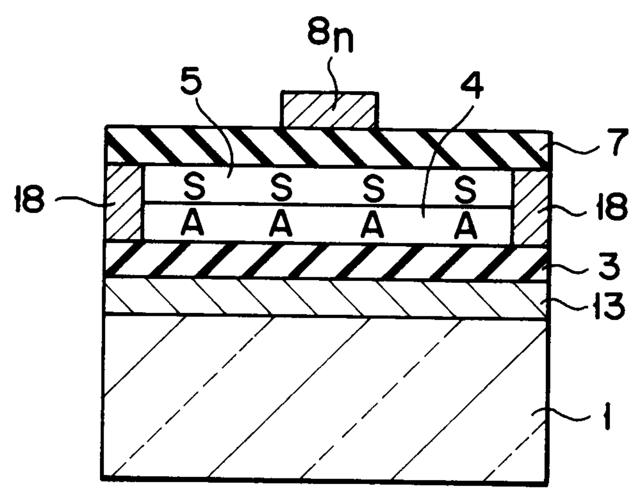
8n
5
4
7
18
S S S S
18
A A A A
3
13
1

F I G. 48

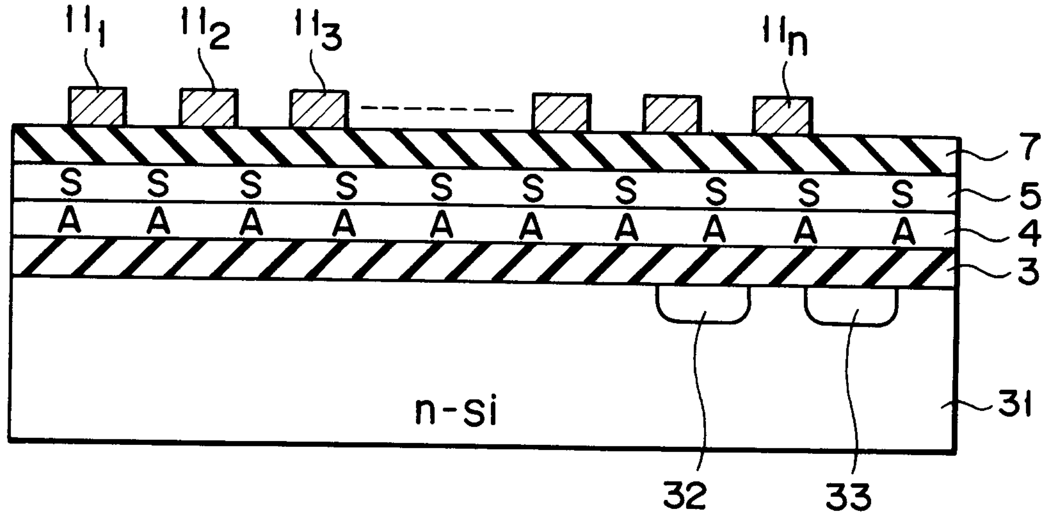
$11_1$
$11_2$
$11_3$
$11_n$
7
5
4
3
31
32
33
S
A
n-si

F I G. 49

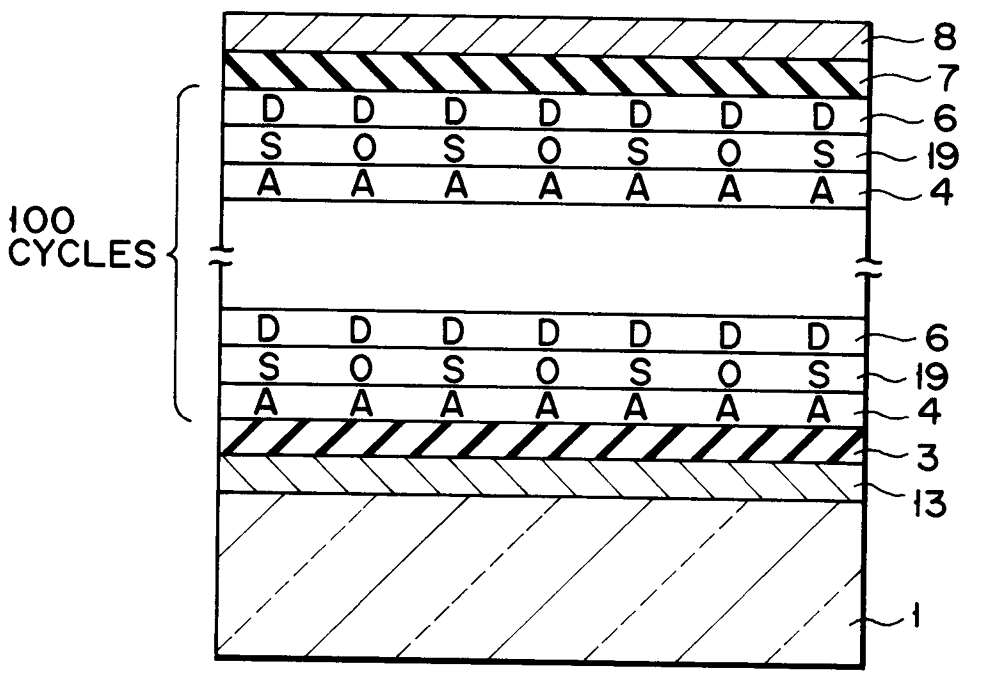
8
7
6
19
4
3
13
1
100 CYCLES
D
S O
A

F I G. 50

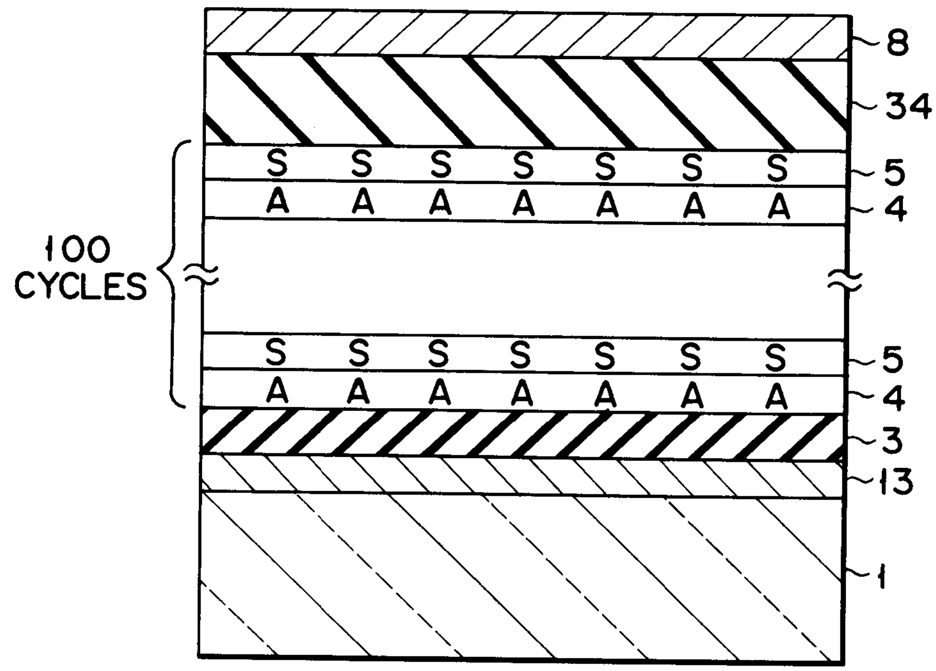
8
34
100
CYCLES
S S S S S S S
A A A A A A A
5
4
3
13
1

FIG. 51

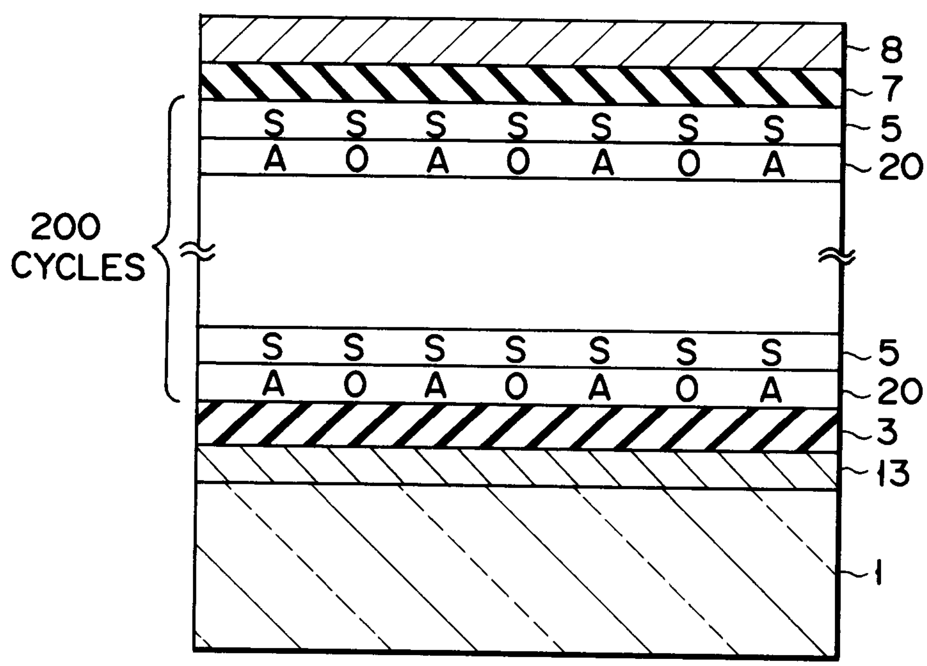
8
7
200
CYCLES
S S S S S S S
A O A O A O A
5
20
3
13
1

FIG. 52